# EUROPEAN PATENT SPECIFICATION

(11) **EP 2 950 143 B1**
(45) Date of publication and mention of the grant of the patent: **20.07.2016**
(21) Application number: 15169359.5
(22) Date of filing: 27.05.2015
(51) Int. Cl.: G03F 7/004, G03F 7/039, G03F 7/32

(54) **RESIST COMPOSITION AND PATTERNING PROCESS**
RESISTZUSAMMENSETZUNG UND STRUKTURIERUNGSVERFAHREN
COMPOSITION RÉSISTANTE ET PROCÉDÉ DE FORMATION DE MOTIFS

(30) Priority: 28.05.2014 JP 2014110532
(43) Date of publication of application: 02.12.2015
(73) Proprietor: Shin-Etsu Chemical Co., Ltd., Tokyo (JP)
(72) Inventor: ADACHI, Teppei, Joetsu-shi, Niigata (JP); SAGEHASHI, Masayoshi, Joetsu-shi, Niigata (JP); OHASHI, Masaki, Joetsu-shi, Niigata (JP); HASEGAWA, Koji, Joetsu-shi, Niigata (JP); KOBAYASHI, Tomohiro, Joetsu-shi, Niigata (JP); OIKAWA, Kenichi, Joetsu-shi, Niigata (JP)
(74) Representative: Ter Meer Steinmeister & Partner

(56) References cited:
- EP-A1- 2 101 217
- EP-A2- 1 939 691
- EP-A2- 2 003 505
- US-A1- 2002 015 826

## Description

### CROSS-REFERENCE TO RELATED APPLICATION

This non-provisional application claims priority under 35 U.S.C. §119(a) on Patent Application No. 2014-110532 filed in Japan on May 28, 2014, the entire contents of which are hereby incorporated by reference.

### TECHNICAL FIELD

This invention relates to a pattern forming process involving exposure of a resist film, deprotection reaction with the aid of acid and heat, and development in an organic solvent to form a negative tone pattern in which the unexposed region is dissolved and the exposed region is not dissolved, and a resist composition for use in the process.

### BACKGROUND ART

In the lithography technology, a highlight is recently put on the organic solvent development again. It would be desirable if a very fine hole pattern, which is not achievable with the positive tone, is resolvable through negative tone exposure. To this end, a positive resist composition featuring a high resolution is subjected to organic solvent development to form a negative pattern. An attempt to double a resolution by combining two developments, alkaline development and organic solvent development is under study.

As the ArF resist composition for negative tone development with organic solvent, positive ArF resist compositions of the prior art design may be used. Such pattern forming processes are described in Patent Documents 1 to 3. These patent documents disclose resist compositions for organic solvent development comprising a copolymer of hydroxyadamantane methacrylate, a copolymer of norbornane lactone methacrylate, and a copolymer of methacrylate having acidic groups including carboxyl, sulfo, phenol and thiol groups substituted with two or more acid labile groups, and pattern forming processes using the same.

Further, Patent Document 4 discloses a process for forming a pattern through organic solvent development in which a protective film is applied onto a resist film. Patent Document 5 discloses a topcoatless process for forming a pattern through organic solvent development in which an additive is added to a resist composition so that the additive may segregate at the resist film surface after spin coating to provide the surface with improved water repellency.

The positive development system involving deprotection reaction to generate a carboxyl group and subsequent neutralization reaction with aqueous alkaline developer to improve a dissolution rate achieves a high dissolution contrast in that the dissolution rate differs between the unexposed and exposed regions by a factor of more than 1,000. In contrast, the negative development system via organic solvent development provides a low contrast because the dissolution rate in the unexposed region due to solvation is low, and the dissolution rate thus differs between the unexposed and exposed regions by a factor of less than 100. For the negative development system via organic solvent development, it is desired to seek for a novel material which can enhance a dissolution contrast.

### Citation List

Patent Document 1: JP-A 2008-281974
Patent Document 2: JP-A 2008-281975
Patent Document 3: JP 4554665
Patent Document 4: JP 4590431
Patent Document 5: JP-A 2008-309879

### DISCLOSURE OF INVENTION

The organic solvent development is low in dissolution contrast, as compared with the positive resist system adapted to become dissolvable in alkaline developer when deprotection reaction takes place to produce acidic carboxyl or phenol groups. Specifically, in the case of alkaline developer, the alkali dissolution rate differs more than 1,000 times between unexposed and exposed regions, whereas the difference in the case of organic solvent development is at most 100 times, and only about 10 times for certain materials. No sufficient margin is available. In the case of aqueous alkaline development, the dissolution rate is improved by neutralization reaction with carboxyl groups. In the case of organic solvent development with no accompanying reaction, the dissolution rate is low because dissolution is solely due to solvation. It is necessary not only to improve the dissolution rate of the unexposed region, but also to reduce the dissolution rate of the exposed region that is a remaining portion of resist film. If the dissolution rate of the exposed region is high, the thickness of the remaining film is so reduced that the underlying substrate may not be processed by etching through the pattern as developed. Further it is important to enhance the gradient or gamma (γ) at the dose corresponding to dissolution/non-dissolution conversion. A low γ value is prone to form an inversely tapered profile and allows for pattern collapse in the case of a line pattern. To obtain a perpendicular pattern, the resist must have a dissolution contrast having a γ value as high as possible.

While prior art photoresist compositions of the alkaline aqueous solution development type are described in Patent Documents 1 to 3, they have a low dissolution contrast upon organic solvent development. It would be desirable to have a novel material having a significant difference in dissolution rate between the exposed and unexposed regions and capable of achieving a high dissolution contrast (γ) upon organic solvent development.

An object of the invention is to provide a resist composition which has a significant dissolution contrast and a high sensitivity upon organic solvent development. Another object is to provide a pattern forming process using the resist composition.

The inventors have found that a resist composition comprising (A) a resin component comprising recurring units of lactone having the general formula (1) and (B) a photoacid generator having the general formula (2) displays a high dissolution contrast when processed by exposure, PEB and organic solvent development.

When a monocyclic lactone having alkyl groups distributed on its ring is used in negative pattern formation via organic solvent development, its solubility in developer is significantly improved due to the high lipophilicity of pendant alkyl groups. When this resin component is combined with a photoacid generator having controlled acid diffusion, a high dissolution contrast is established. Because of no swell in organic solvent developer, problems like pattern collapse, bridge defect formation, and LWR degradation are overcome. Particularly when a hole pattern is formed, the pattern has improved roundness and dimensional uniformity. It is thus possible to form fine size patterns.

In one aspect, the invention provides a resist composition comprising (A) a resin component comprising recurring units having the general formula (1) and (B) a photoacid generator having the general formula (2). 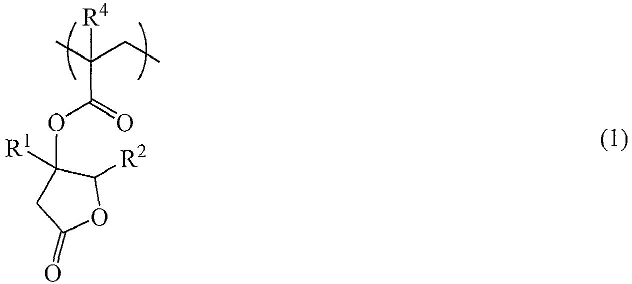 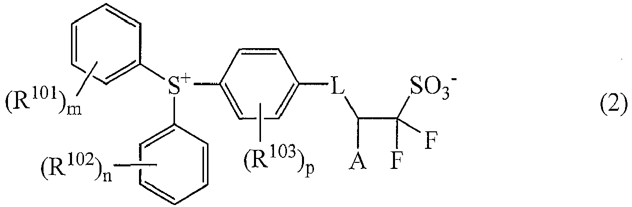 Herein R¹ and R² are each independently C₁-C₃ alkyl, R⁴ is hydrogen or methyl, A is hydrogen or trifluoromethyl, R¹⁰¹, R¹⁰² and R¹⁰³ are each independently hydrogen or a straight, branched or cyclic C₁-C₂₀ monovalent hydrocarbon group optionally substituted with heteroatoms, which may be linked to the phenyl ring by a heteroatom, m and n each are an integer of 0 to 5, p is an integer of 0 to 4, and L is a single bond, an oxygen atom or a straight, branched or cyclic C₁-C₂₀ divalent hydrocarbon group which may be substituted with or separated by a heteroatom.

In a preferred embodiment, the resin component (A) further comprises recurring units having the general formula (3) : 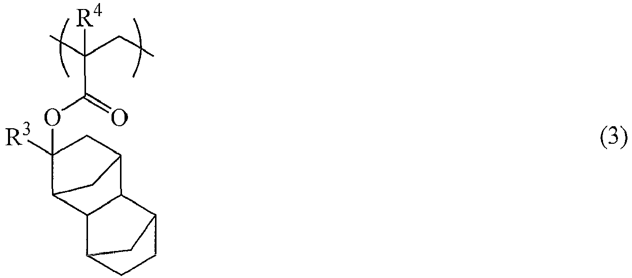 wherein R³ is straight or branched C₁-C₄ alkyl, and R⁴ is hydrogen or methyl.

In another preferred embodiment, the resin component (A) further comprises recurring units having the general formula (4): 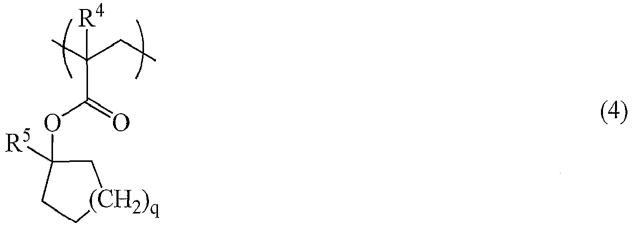 wherein R⁵ is straight or branched C₁-C₆ alkyl, R⁴ is hydrogen or methyl, and q is 1 or 2.

In a preferred embodiment, the resist composition may further comprise (Z) a sulfonium salt of sulfonic acid or carboxylic acid having the general formula (Z1) or (Z2). 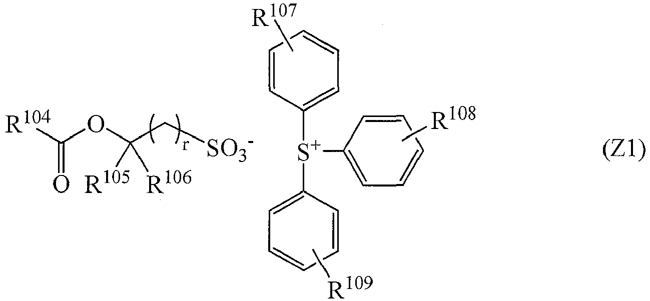 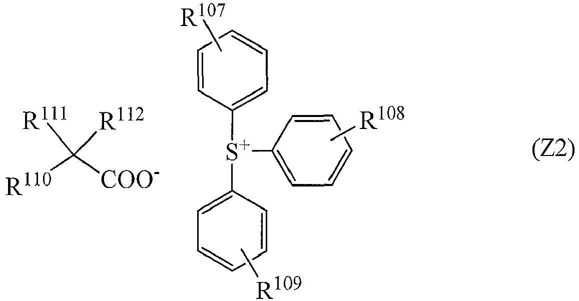 Herein R¹⁰⁵, R¹⁰⁶, R¹¹¹, and R¹¹² are hydrogen or trifluoromethyl, R¹⁰⁴ is a straight, branched or cyclic C₁-C₃₅ monovalent hydrocarbon group which may contain an oxygen atom, r is an integer of 0 to 3, R¹¹⁰ is hydrogen, hydroxyl, a straight, branched or cyclic C₁-C₃₅ monovalent hydrocarbon group which may contain an oxygen atom, or a substituted or unsubstituted C₆-C₃₀ aryl group, R¹⁰⁷, R¹⁰⁸, and R¹⁰⁹ are each independently hydrogen, a substituted or unsubstituted, straight or branched C₁-C₁₀ alkyl, alkenyl or oxoalkyl group, or a substituted or unsubstituted C₆-C₁₈ aryl, aralkyl or aryloxoalkyl group, or any two or more of R¹⁰⁷, R¹⁰⁸, and R¹⁰⁹ may bond together to form a ring with the sulfur atom.

In another aspect, the invention provides a process for forming a pattern, comprising the steps of applying a resist composition comprising (A) a resin component comprising recurring units having the above formula (1) and (B) a photoacid generator having the above formula (2) onto a substrate, baking the composition to form a resist film, exposing the resist film to high-energy radiation to define exposed and unexposed regions, baking, and applying an organic solvent developer to form a negative pattern wherein the unexposed region of resist film is dissolved and the exposed region of resist film is not dissolved.

In a preferred embodiment, the resin component (A) further comprises recurring units having the above formula (3) and/or recurring units having the above formula (4); the resist composition may further comprises (Z) a sulfonium salt of sulfonic acid or carboxylic acid having the above formula (Z1) or (Z2).

Preferably, the developer comprises at least one organic solvent selected from among 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, amyl acetate, isoamyl acetate, butenyl acetate, propyl formate, butyl formate, isobutyl formate, amyl formate, isoamyl formate, methyl valerate, methyl pentenoate, methyl crotonate, ethyl crotonate, methyl propionate, ethyl propionate, ethyl 3-ethoxypropionate, methyl lactate, ethyl lactate, propyl lactate, butyl lactate, isobutyl lactate, amyl lactate, isoamyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate.

Further preferably, the step of exposing the resist film to high-energy radiation includes KrF excimer laser lithography of wavelength 248 nm, ArF excimer laser lithography of wavelength 193 nm, EUV lithography of wavelength 13.5 nm or EB lithography.

### ADVANTAGEOUS EFFECTS OF INVENTION

The resist composition displays a high dissolution contrast when processed by exposure, PEB and organic solvent development. A fine size hole pattern with improved roundness and dimensional uniformity is formed. Fine size patterns are consistently formed.

### BRIEF DESCRIPTION OF DRAWINGS

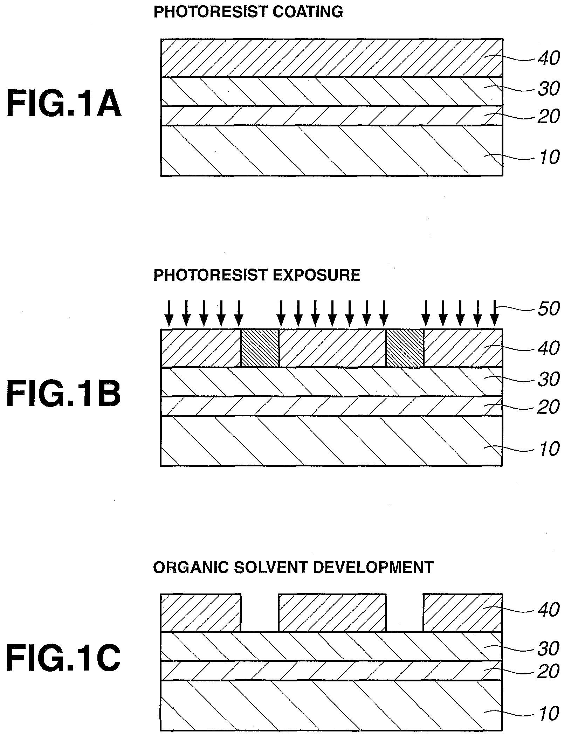

The only figure, FIG. 1 is a cross-sectional view of a patterning process according one embodiment of the invention.
FIG. 1 (A) shows a photoresist film disposed on a substrate,
FIG. 1 (B) shows the resist film being exposed, and FIG. 1(C) shows the resist film being developed in an organic solvent.

### DESCRIPTION OF EMBODIMENTS

As used herein, the notation (Cₙ-Cₘ) means a group containing from n to m carbon atoms per group. As used herein, the term "film" is used interchangeably with "coating" or "layer." In the chemical formulae, Me stands for methyl, Ph for phenyl, and Ac for acetyl.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator

Briefly stated, the invention pertains to a resist composition comprising (A) a resin component of lactone having alkyl groups distributed on its ring, specifically recurring units having formula (1), and (B) a photoacid generator, specifically having formula (2); and a pattern forming process comprising the steps of applying the resist composition onto a substrate, prebaking to remove the unnecessary solvent and form a resist film, exposing a selected region of the resist film to high-energy radiation, PEB, and developing the exposed film in an organic solvent-based developer to form a negative pattern.

For the purpose of enhancing the dissolution rate of the unexposed region during organic solvent development, it is effective to introduce an alkyl group into lactone ring. The distribution of alkyl groups promotes solvation in organic solvent developer, achieving an improvement in solvent solubility over the lactone ring free of pendant alkyl groups.

When the resin component having recurring units of the above lactone structure is combined with a photoacid generator featuring controlled acid diffusion, a high dissolution contrast is achievable. Then a pattern of satisfactory profile can be formed.

Component (A) in the resist composition is a resin comprising recurring units having the general formula (1). 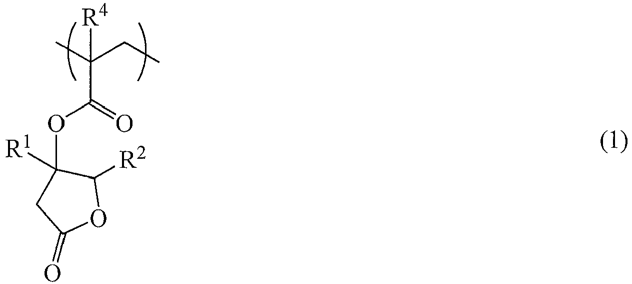 Herein R¹ and R² are each independently C₁-C₃ alkyl, and R⁴ is hydrogen or methyl.

Illustrative, non-limiting examples of the recurring units having formula (1) are given below.

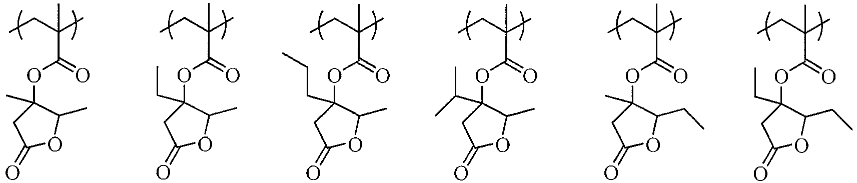

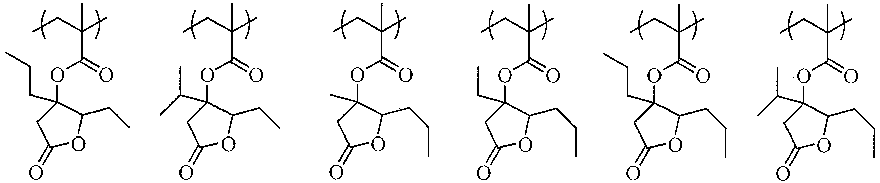

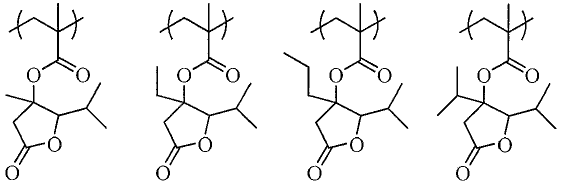

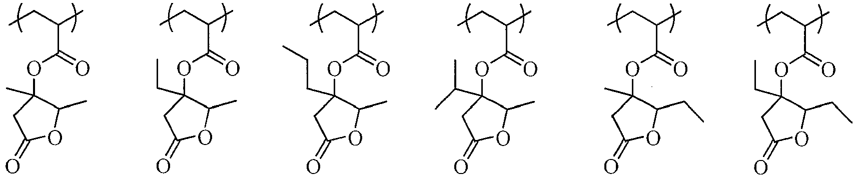

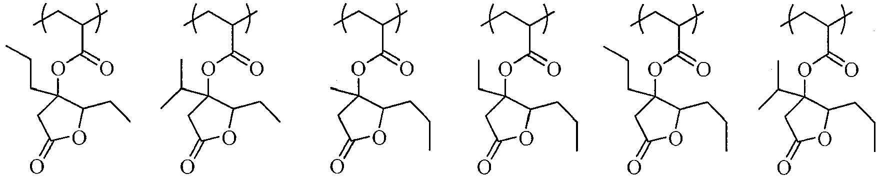

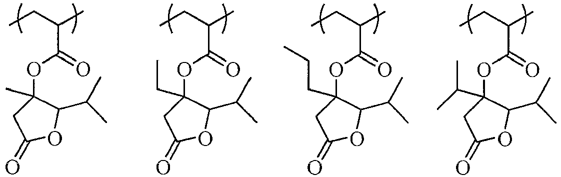

Of the recurring units having formula (1), those units shown below are especially preferred.

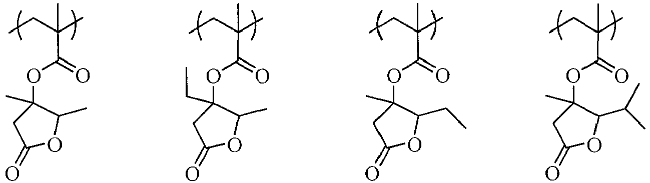

In addition to the recurring units having formula (1), preferably the resin component (A) further comprises recurring units having the general formula (3). Inclusion of recurring units of formula (3) ensures a sufficient dissolution contrast. 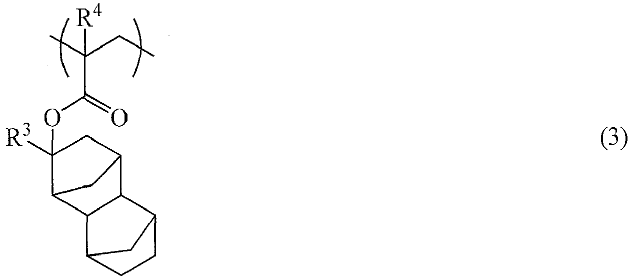 Herein R³ is straight or branched C₁-C₄ alkyl, and R⁴ is hydrogen or methyl.

Preferred examples of the recurring units having formula (3) are given below.

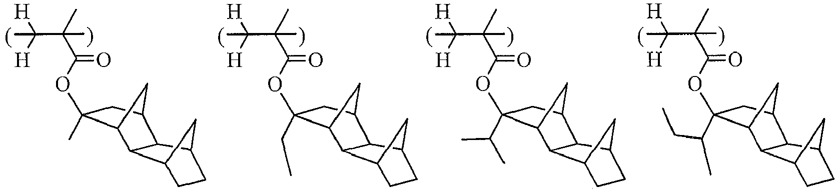

In addition to the recurring units having formula (1), preferably the resin component (A) may further comprise recurring units having the general formula (4). Inclusion of recurring units of formula (4) ensures an improvement in resolution. 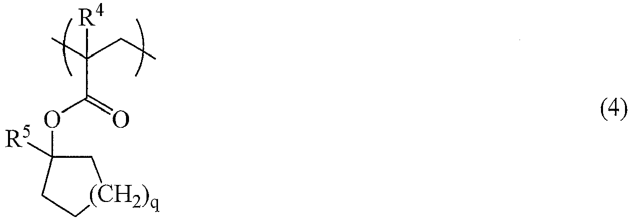 Herein R⁵ is straight or branched C₁-C₆ alkyl, R⁴ is hydrogen or methyl, and q is 1 or 2.

Illustrative, non-limiting examples of the recurring units having formula (4) are given below.

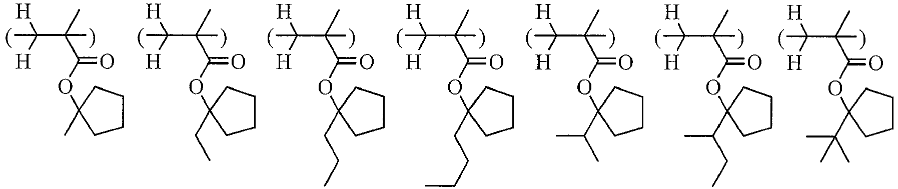

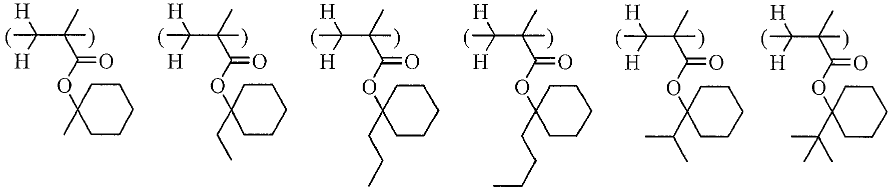

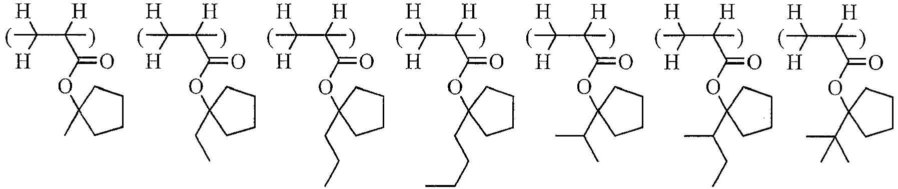

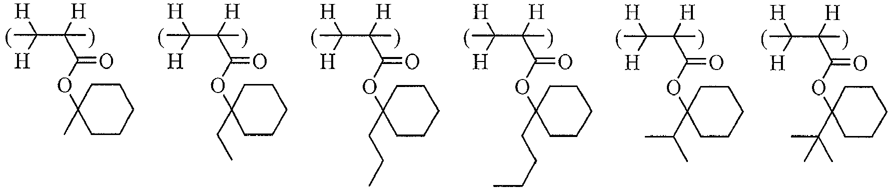

Of the recurring units having formula (4), those units shown below are especially preferred.

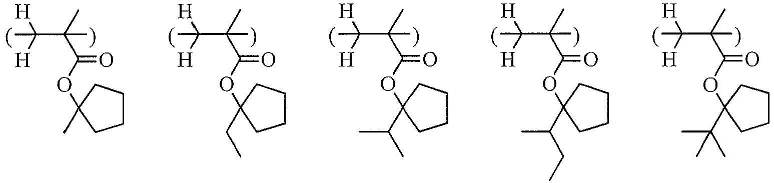

The resin as component (A) may comprise additional recurring units other than the recurring units of lactone having formula (1) and recurring units having formulae (3) and (4). Suitable additional recurring units include recurring units having a carboxyl group or fluoroalkyl group. Illustrative, non-limiting examples of the recurring units having a carboxyl or fluoroalkyl group are shown below.

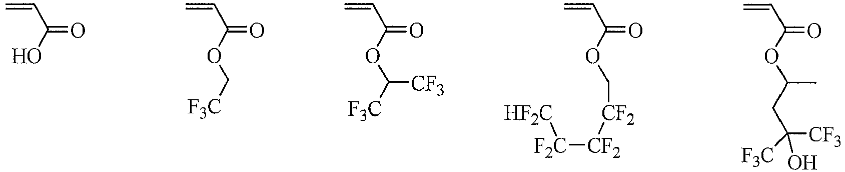

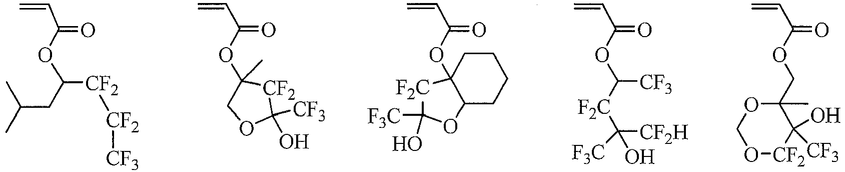

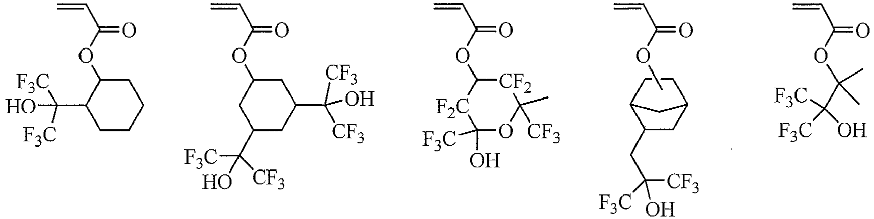

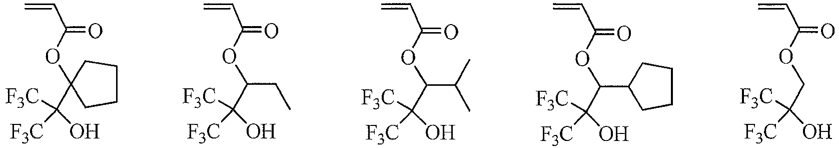

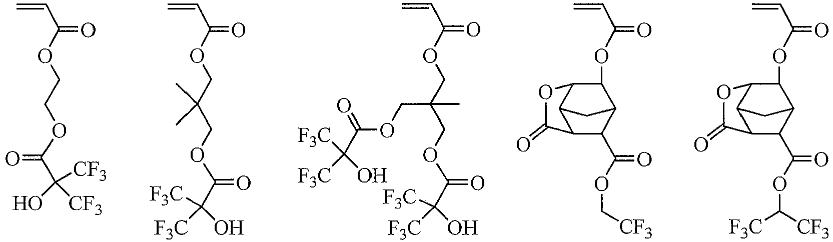

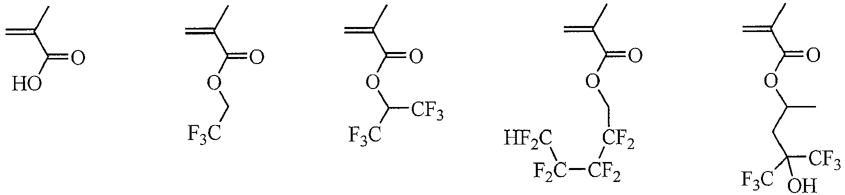

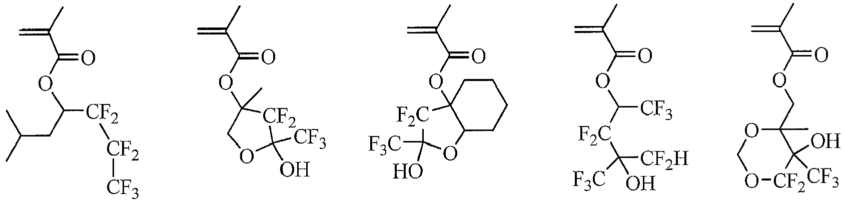

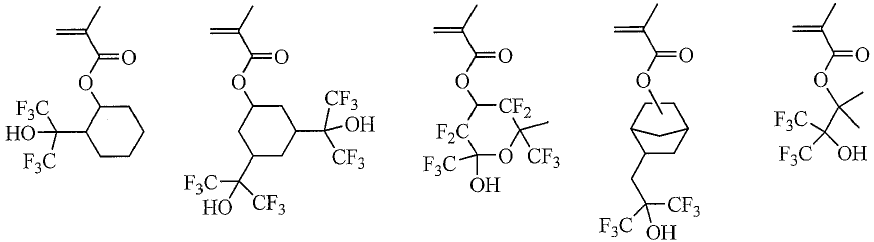

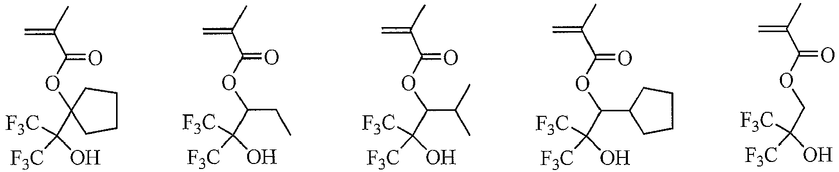

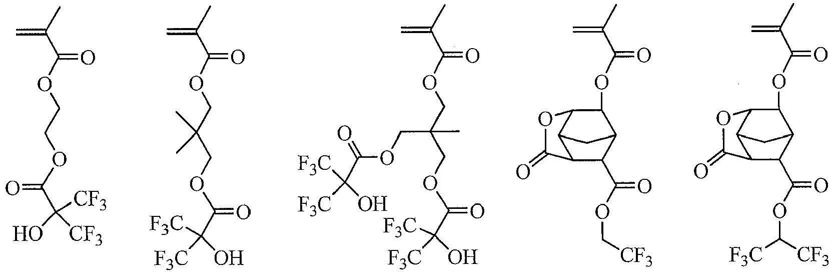

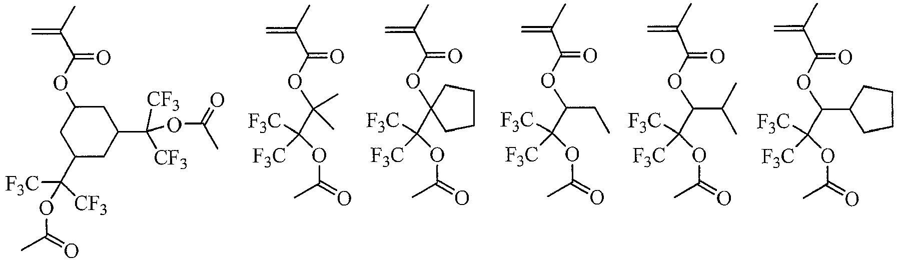

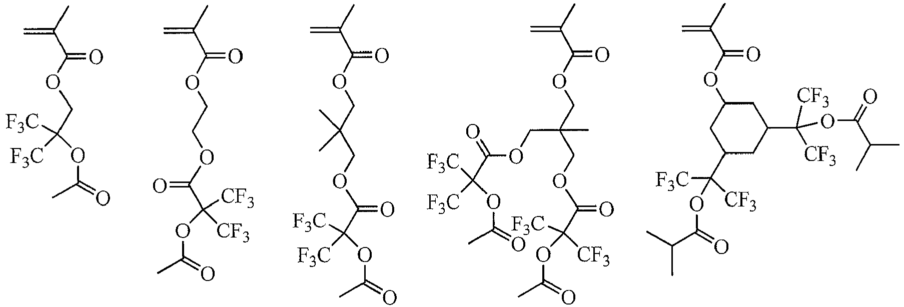

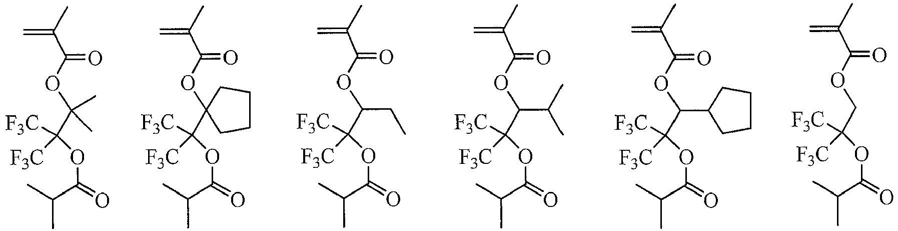

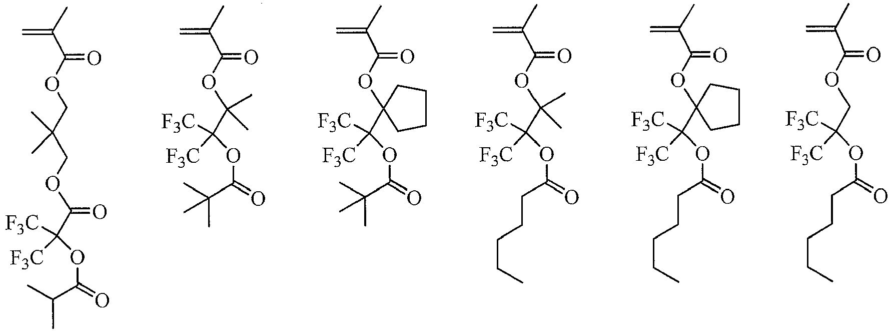

The polymer serving as the base resin in the resist composition used in the pattern forming process of the invention should preferably have a weight average molecular weight (Mw) in the range of 1,000 to 500,000, and more preferably 3,000 to 15,000, as measured by GPC versus polystyrene standards using tetrahydrofuran solvent. With too low a Mw, a film thickness loss is likely to occur upon organic solvent development. A polymer with too high a Mw may lose solubility in organic solvent and have a likelihood of footing after pattern formation.

If a polymer has a wide molecular weight distribution or dispersity (Mw/Mn), which indicates the presence of lower and higher molecular weight polymer fractions, there is a possibility that following exposure, foreign matter is left on the pattern or the pattern profile is exacerbated. The influences of molecular weight and dispersity become stronger as the pattern rule becomes finer. Therefore, the multi-component copolymer should preferably have a narrow dispersity (Mw/Mn) of 1.0 to 2.0, especially 1.0 to 1.5, in order to provide a resist composition suitable for micropatterning to a small feature size.

The polymer used herein may be synthesized by any desired method, for example, by dissolving unsaturated bond-containing monomers corresponding to the recurring unit having formula (1), optional recurring units having formulae (3) and (4), and additional recurring units in an organic solvent, adding a radical initiator thereto, and effecting heat polymerization. Examples of the organic solvent which can be used for polymerization include toluene, benzene, tetrahydrofuran, diethyl ether and dioxane. Examples of the polymerization initiator used herein include 2,2'-azobisisobutyronitrile (AIBN), 2,2'-azobis(2,4-dimethyl-valeronitrile), dimethyl 2,2-azobis(2-methylpropionate), benzoyl peroxide, and lauroyl peroxide. Preferably the system is heated at 50 to 100°C for polymerization to take place. The reaction time is preferably 4 to 24 hours. The acid labile group that has been incorporated in the monomer may be kept as such, or the product may be protected or partially protected after polymerization.

It is acceptable to use a blend of two or more polymers which differ in compositional ratio, molecular weight or dispersity as well as a blend of an inventive polymer and another polymer free of lactone as represented by formula (1).

In a further embodiment, the inventive polymer may be blended with a polymer of the conventional type wherein the exposed region is dissolved on alkaline development such as (meth)acrylate polymer, polynorbornene, cycloolefin-maleic anhydride copolymer, or ring-opening metathesis polymerization (ROMP) polymer. Also, the inventive polymer may be blended with a (meth)acrylate polymer, polynorbornene, or cycloolefin-maleic anhydride copolymer having an acid labile group-substituted hydroxyl group wherein the exposed region is not dissolved by alkaline development, but a negative pattern is formed by organic solvent development.

The resist composition of the invention also contains (B) a photoacid generator having the general formula (2). Better results are obtained particularly when a PAG having formula (2) wherein A is trifluoromethyl is used. 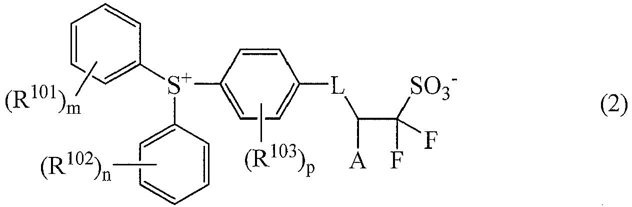 Herein A is hydrogen or trifluoromethyl, R¹⁰¹, R¹⁰² and R¹⁰³ are each independently hydrogen or a straight, branched or cyclic C₁-C₂₀ monovalent hydrocarbon group, optionally substituted with heteroatoms, which may be linked to the phenyl ring by a heteroatom, m and n each are an integer of 0 to 5, p is an integer of 0 to 4, and L is a single bond, an oxygen atom or a straight, branched or cyclic C₁-C₂₀ divalent hydrocarbon group which may be substituted with or separated by a heteroatom.

Illustrative, non-limiting examples of the PAG having formula (2) are shown by the following structures. 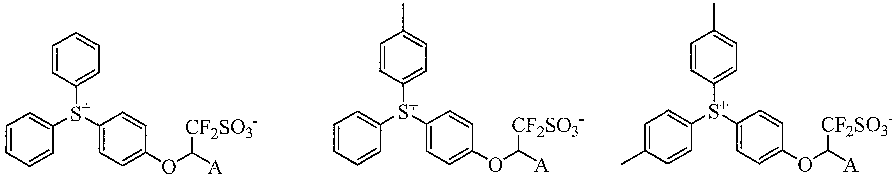 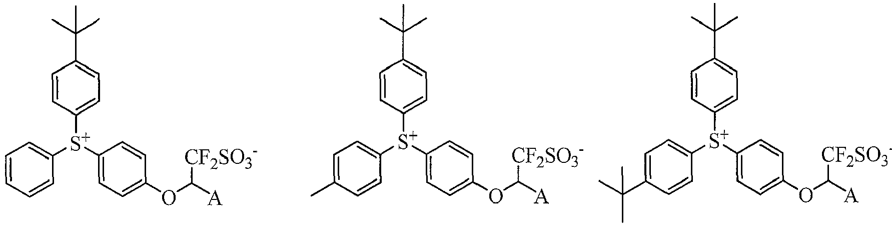 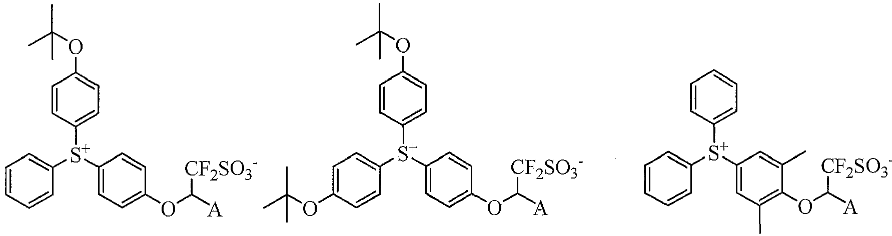 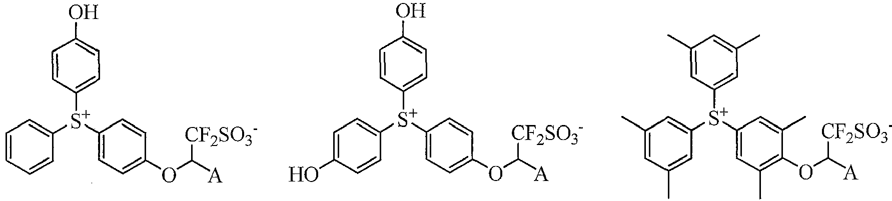 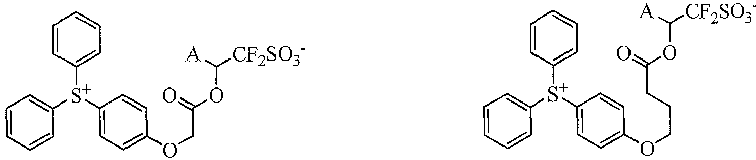 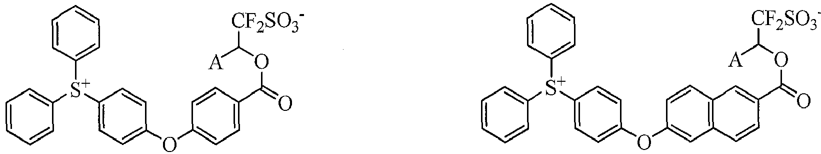 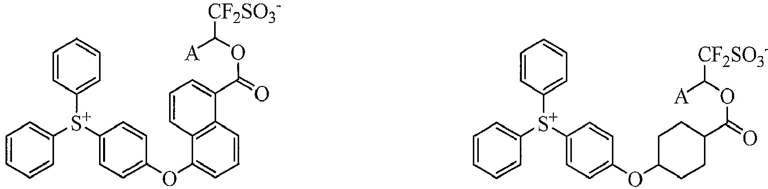 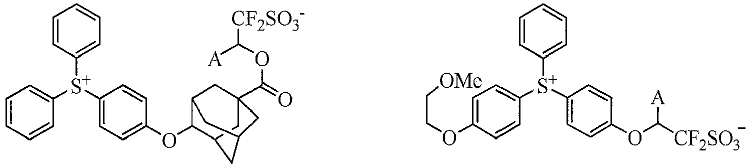 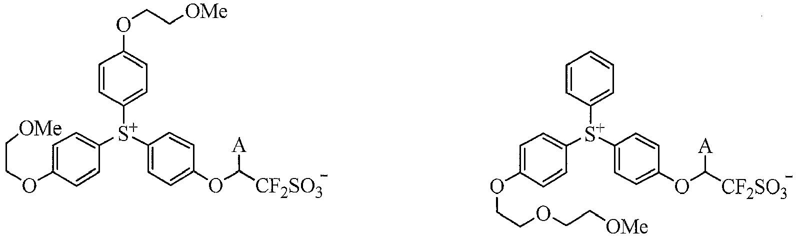 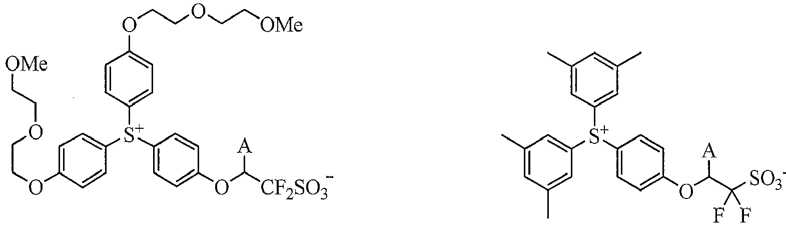 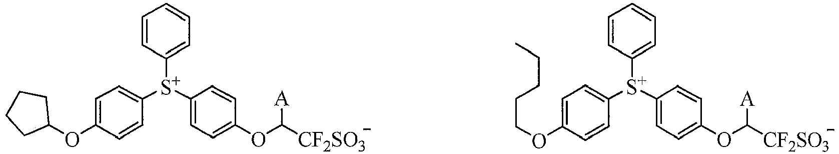 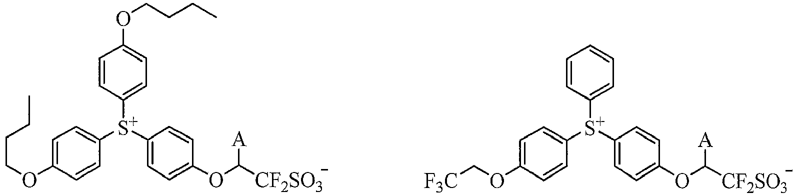 Herein A is hydrogen or trifluoromethyl.

If desired, the resist composition may comprise an acid generator other than the PAG of formula (2). Typical of the acid generator used herein is a photoacid generator (PAG) capable of generating an acid in response to high-energy radiation. The PAG may be any of well-known PAGs commonly used in resist compositions, especially chemically amplified resist compositions. Suitable PAGs include sulfonium salts, iodonium salts, sulfonyldiazomethane, N-sulfonyloxyimide, and oxime-O-sulfonate acid generators, which may be used alone or in admixture of two or more. Illustrative, non-limiting examples of the PAG which can be additionally used are shown by the following structures.

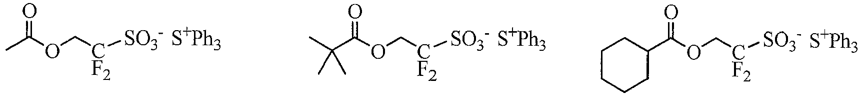

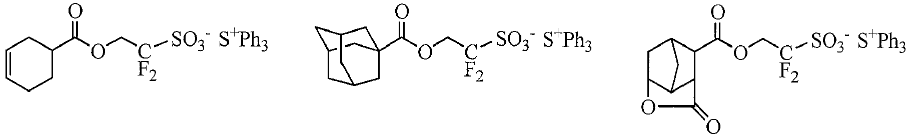

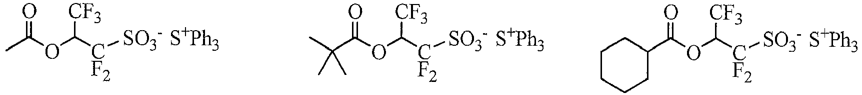

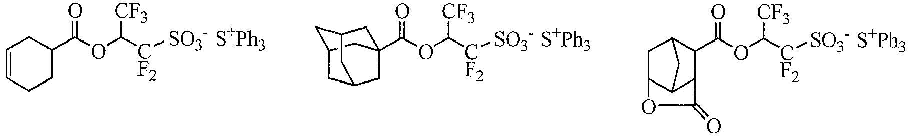

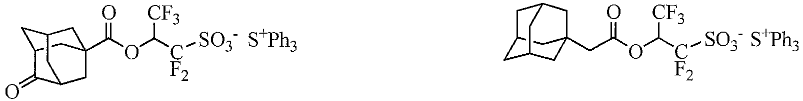

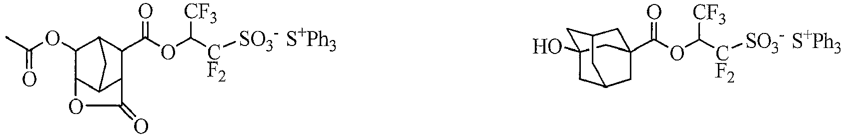

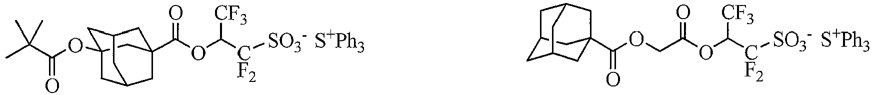

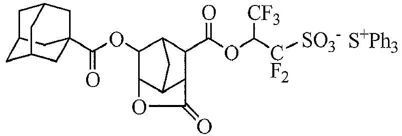

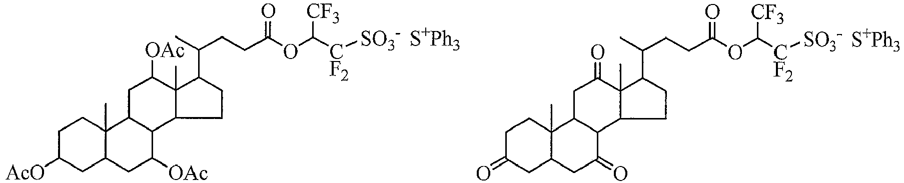

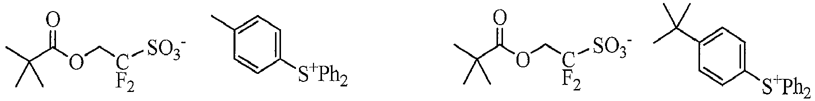

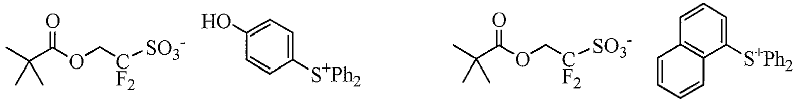

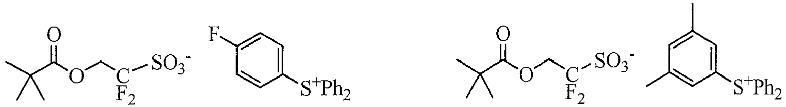

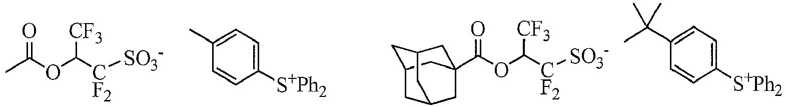

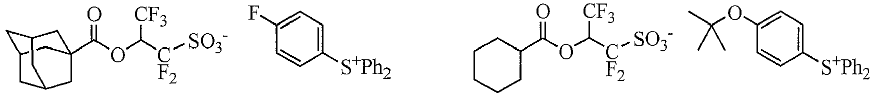

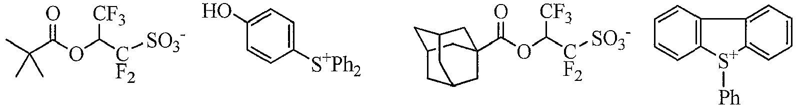

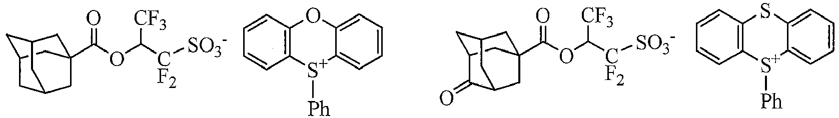

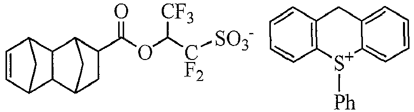

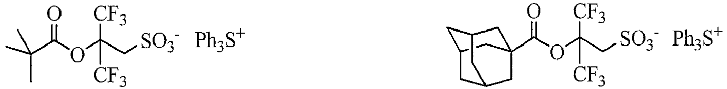

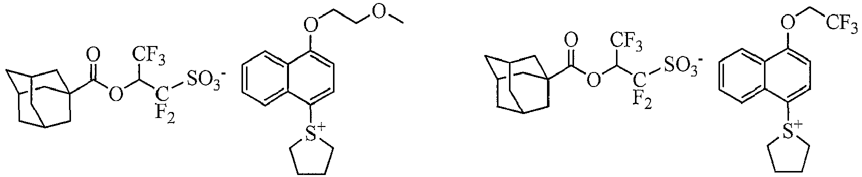

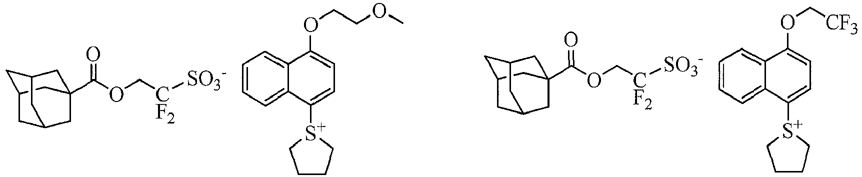

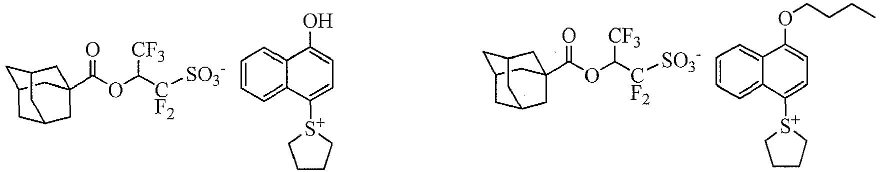

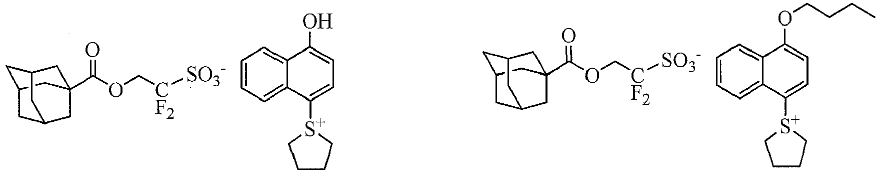

In a preferred embodiment, the resist composition further comprises (Z) a sulfonium salt of sulfonic acid or carboxylic acid having the general formula (Z1) or (Z2). 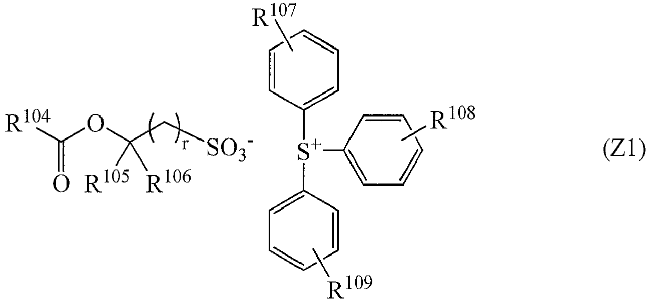 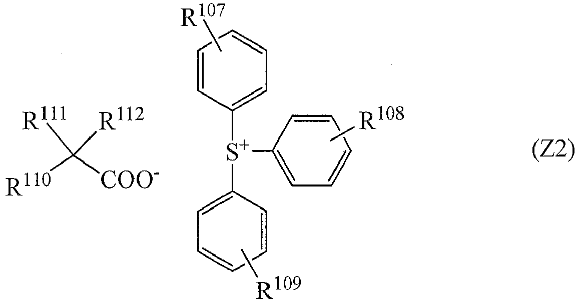 Herein R¹⁰⁵, R¹⁰⁶, R¹¹¹, and R¹¹² are hydrogen or trifluoromethyl, R¹⁰⁴ is a straight, branched or cyclic C₁-C₃₅ monovalent hydrocarbon group which may contain an oxygen atom, r is an integer of 1 to 3, R¹¹⁰ is hydrogen, hydroxyl, a straight, branched or cyclic C₁-C₃₅ monovalent hydrocarbon group which may contain an oxygen atom, or a substituted or unsubstituted C₆-C₃₀ aryl group, R¹⁰⁷, R¹⁰⁸, and R¹⁰⁹ are each independently hydrogen, a substituted or unsubstituted, straight or branched C₁-C₁₀ alkyl, alkenyl or oxoalkyl group, or a substituted or unsubstituted C₆-C₁₈ aryl, aralkyl or aryloxoalkyl group, or any two or more of R¹⁰⁷, R¹⁰⁸, and R¹⁰⁹ may bond together to form a ring with the sulfur atom.

Illustrative, non-limiting examples of the sulfonium salt of sulfonic acid or carboxylic acid having formula (Z1) or (Z2) are shown by the following structures.

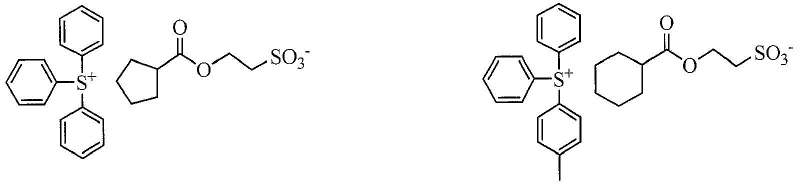

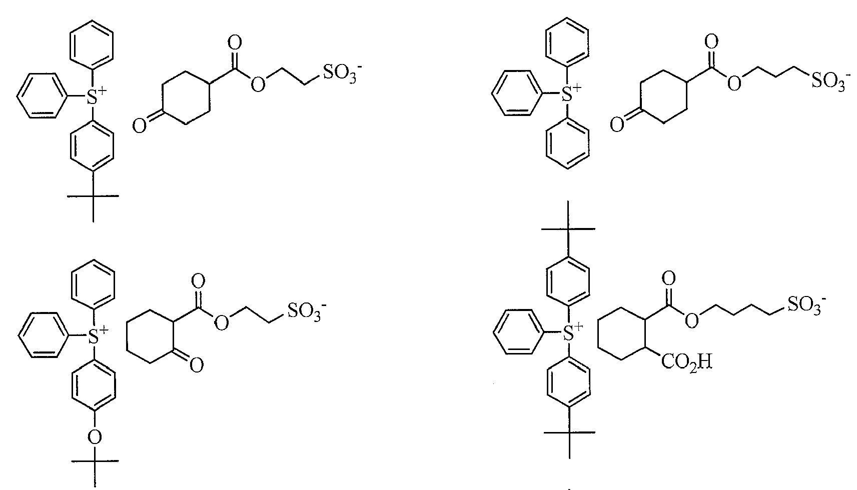

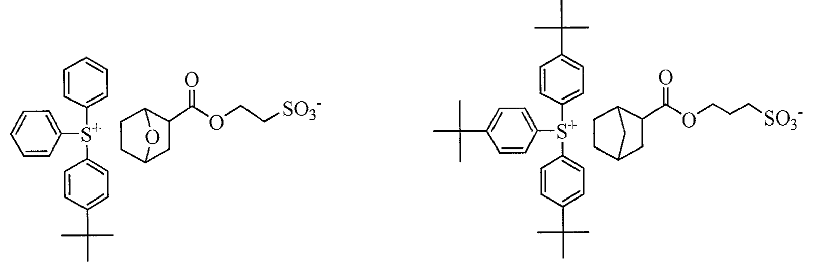

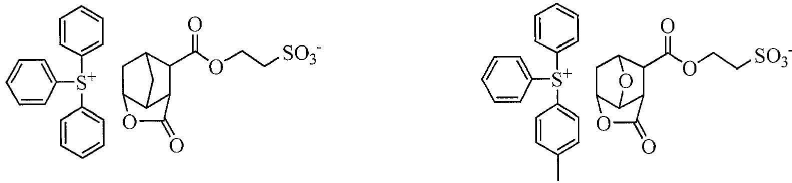

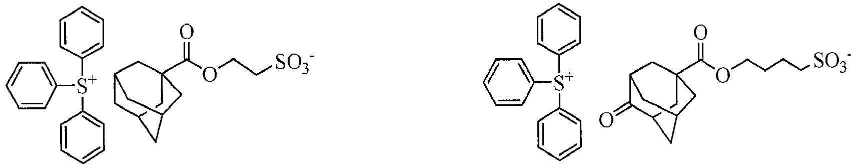

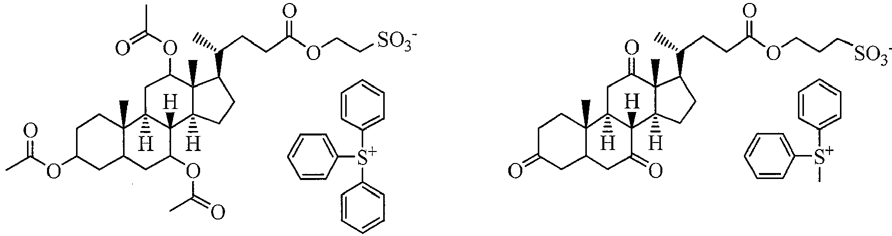

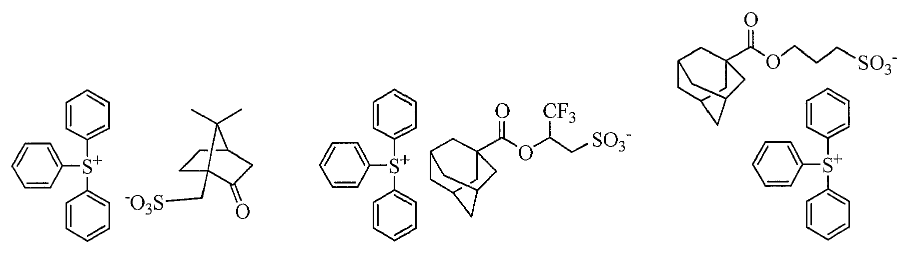

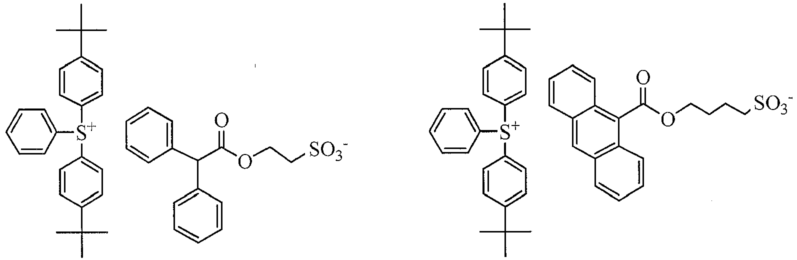

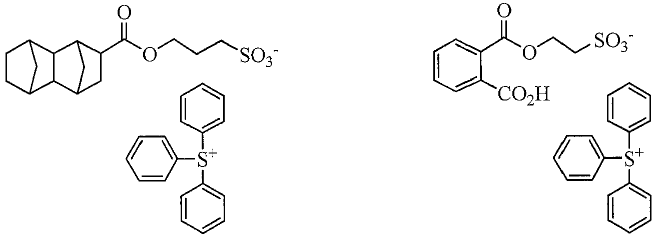

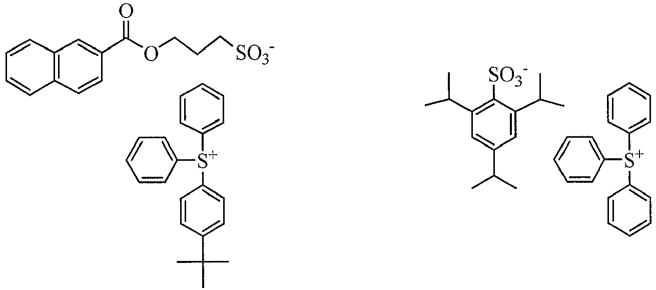

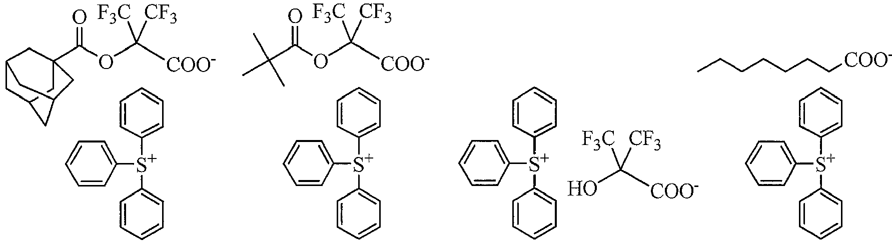

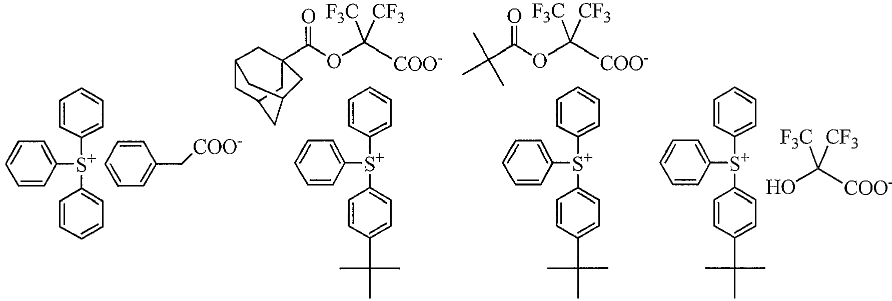

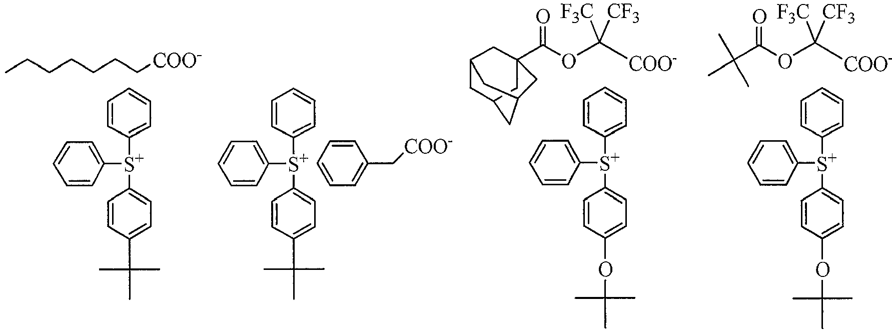

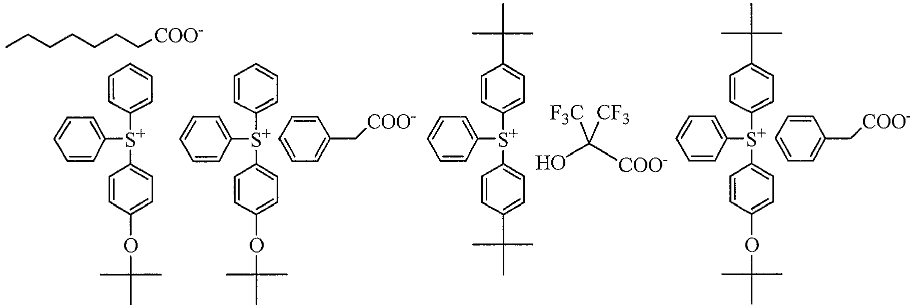

If desired, the resist composition may further comprise a basic compound, organic solvent, surfactant, dissolution regulator, acetylene alcohol and the like.

The basic compound is preferably a compound capable of holding down the diffusion rate of acid when the acid generated by the acid generator diffuses in the resist film. The inclusion of the basic compound holds down the diffusion rate of acid in the resist film, which leads to many advantages including improved resolution, minimized sensitivity change following exposure, reduced substrate poisoning and environment dependency, and improved exposure latitude and pattern profile.

Exemplary basic compounds include primary, secondary and tertiary amine compounds, specifically amine compounds having a hydroxyl, ether, ester, lactone, cyano or sulfonic acid ester group, as described in JP-A 2008-111103, paragraphs [0146] to [0164] (USP 7,537,880), and compounds having a carbamate group, as described in JP 3790649. The basic compound is preferably used in an amount of 0 to 5 parts, more preferably 0.1 to 5 parts by weight per 100 parts by weight of the base resin.

Exemplary organic solvents are described in JP-A 2008-111103, paragraphs [0144] to [0145], and include ketones such as cyclohexanone and methyl 2-n-amyl ketone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate; and lactones such as γ-butyrolactone, which may be used alone or in admixture. Where the acid labile group used in the base resin is an acetal group, a high-boiling alcohol solvent such as diethylene glycol, propylene glycol, glycerol, 1,4-butanediol or 1,3-butanediol may be added to accelerate the deprotection reaction of acetal. An appropriate amount of the organic solvent used is 100 to 10,000 parts, and especially 300 to 8,000 parts by weight per 100 parts by weight of the base resin.

Exemplary surfactants are described in JP-A 2008-111103, paragraphs [0165] to [0166]. Exemplary dissolution regulators are described in JP-A 2008-122932 (US 2008090172), paragraphs [0155] to [0178], and exemplary acetylene alcohols in paragraphs [0179] to [0182]. Amounts of surfactant, dissolution regulator, and acetylene alcohol may be determined as appropriate for their particular purpose.

Also a polymeric additive may be added for improving the water repellency on surface of a resist film as spin coated. This additive may be used in the topcoatless immersion lithography. These additives have a specific structure with a 1,1,1,3,3,3-hexafluoro-2-propanol residue and are described in JP-A 2007-297590 and JP-A 2008-111103. The water repellency improver to be added to the resist composition should be soluble in the organic solvent as the developer. The water repellency improver of specific structure with a 1,1,1,3,3,3-hexafluoro-2-propanol residue is well soluble in the developer. A polymer having an amino group or amine salt copolymerized as recurring units may serve as the water repellent additive and is effective for preventing evaporation of acid during PEB and avoiding any hole pattern opening failure after development. An appropriate amount of the water repellency improver is 0.1 to 20 parts, preferably 0.5 to 10 parts by weight per 100 parts by weight of the base resin.

### Process

The pattern forming process of the invention comprises the steps of coating a resist composition onto a substrate, prebaking the resist composition to form a resist film, exposing a selected region of the resist film to high-energy radiation, baking (PEB), and developing the exposed resist film in an organic solvent developer so that the unexposed region of resist film is dissolved and the exposed region of resist film is left. In this way, a negative tone resist pattern such as a hole or trench pattern is formed.

FIG. 1 illustrates the pattern forming process of the invention. First, the resist composition is coated on a substrate to form a resist film thereon. Specifically, a resist film 40 of a resist composition is formed on a processable substrate 20 disposed on a substrate 10 directly or via an intermediate intervening layer 30 as shown in FIG. 1 (A). The resist film preferably has a thickness of 10 to 1,000 nm and more preferably 20 to 500 nm. Prior to exposure, the resist film is heated or prebaked, preferably at a temperature of 60 to 180°C, especially 70 to 150°C for a time of 10 to 300 seconds, especially 15 to 200 seconds.

The substrate 10 used herein is generally a silicon substrate. The processable substrate (or target film) 20 used herein includes SiO₂, SiN, SiON, SiOC, p-Si, α-Si, TiN, WSi, BPSG, SOG, Cr, CrO, CrON, MoSi, low dielectric film, and etch stopper film. The intermediate intervening layer 30 includes hard masks of SiO₂, SiN, SiON or p-Si, an undercoat in the form of carbon film, a silicon-containing intermediate film, and an organic antireflective coating.

Next comes exposure depicted at 50 in FIG. 1 (B). For the exposure, preference is given to high-energy radiation having a wavelength of 140 to 250 nm, EUV having a wavelength of 13.5 nm, and EB, and especially ArF excimer laser radiation of 193 nm. The exposure may be done either in a dry atmosphere such as air or nitrogen stream or by immersion lithography in water. The ArF immersion lithography uses deionized water or liquids having a refractive index of at least 1 and highly transparent to the exposure wavelength such as alkanes as the immersion solvent. The immersion lithography involves prebaking a resist film and exposing the resist film to light through a projection lens, with water or liquid introduced between the resist film and the projection lens. Since this allows lenses to be designed to a NA of 1.0 or higher, formation of finer feature size patterns is possible. The immersion lithography is important for the ArF lithography to survive to the 45-nm node. In the case of immersion lithography, deionized water rinsing (or post-soaking) may be carried out after exposure for removing water droplets left on the resist film, or a protective film may be applied onto the resist film after pre-baking for preventing any leach-out from the resist film and improving water slip on the film surface.

The resist protective film used in the immersion lithography is preferably formed from a solution of a polymer having 1,1,1,3,3,3-hexafluoro-2-propanol residues which is insoluble in water, but soluble in an alkaline developer liquid, in a solvent selected from alcohols of at least 4 carbon atoms, ethers of 8 to 12 carbon atoms, and mixtures thereof. The protective film-forming composition used herein may be based on a polymer comprising recurring units derived from a monomer having a 1,1,1,3,3,3-hexafluoro-2-propanol residue. While the protective film must dissolve in the organic solvent developer, the polymer comprising recurring units derived from a monomer having a 1,1,1,3,3,3-hexafluoro-2-propanol residue dissolves in organic solvent developers. In particular, protective film-forming materials having 1,1,1,3,3,3-hexafluoro-2-propanol residues as described in JP-A 2007-025634 and JP-A 2008-003569 readily dissolve in organic solvent developers.

In the protective film-forming composition, an amine compound or amine salt or a polymer having copolymerized therein recurring units containing an amine compound or amine salt may be used. This component is effective for controlling diffusion of the acid generated in the exposed region of the photoresist film to the unexposed region for thereby preventing any hole opening failure. Useful protective film materials having an amine compound added thereto are described in JP-A 2008-003569, and useful protective film materials having an amino group or amine salt copolymerized are described in JP-A 2007-316448. The amine compound or amine salt may be selected from the compounds enumerated as the basic compound to be added to the resist composition. An appropriate amount of the amine compound or amine salt added is 0.01 to 10 parts, preferably 0.02 to 8 parts by weight per 100 parts by weight of the base resin.

After formation of the photoresist film, deionized water rinsing (or post-soaking) may be carried out for extracting the acid generator and the like from the film surface or washing away particles, or after exposure, rinsing (or post-soaking) may be carried out for removing water droplets left on the resist film. If the acid evaporating from the exposed region during PEB deposits on the unexposed region to deprotect the protective group on the surface of the unexposed region, there is a possibility that the surface edges of holes after development are bridged to close the holes. Particularly in the case of negative development, regions surrounding the holes receive light so that acid is generated therein. There is a possibility that the holes are not opened if the acid outside the holes evaporates and deposits inside the holes during PEB. Provision of a protective film is effective for preventing evaporation of acid and for avoiding any hole opening failure. A protective film having an amine compound added thereto is more effective for preventing acid evaporation. On the other hand, a protective film to which an acid compound such as a carboxyl or sulfo group is added or which is based on a polymer having copolymerized therein monomeric units containing a carboxyl or sulfo group is undesirable because of a potential hole opening failure.

The other embodiment of the invention is a process for forming a pattern by applying a resist composition comprising a polymer comprising recurring units of lactone having alkyl groups distributed on its ring, represented by formula (1), and a photoacid generator of formula (2) onto a substrate, baking the composition to form a resist film, forming a protective film on the resist film, exposing the resist film to high-energy radiation to define exposed and unexposed regions, baking, and applying an organic solvent-based developer to the coated substrate to form a negative pattern wherein the unexposed region of resist film and the protective film are dissolved and the exposed region of resist film is not dissolved. The protective film is preferably formed from a composition comprising a polymer bearing a 1,1,1,3,3,3-hexafluoro-2-propanol residue and an amino group or amine salt-containing compound, or a composition comprising a polymer bearing a 1,1,1,3,3,3-hexafluoro-2-propanol residue and having amino group or amine salt-containing recurring units copolymerized, the composition further comprising an alcohol solvent of at least 4 carbon atoms, an ether solvent of 8 to 12 carbon atoms, or a mixture thereof.

Examples of suitable recurring units having a 1,1,1,3,3,3-hexafluoro-2-propanol residue include those derived from hydroxyl-bearing monomers selected from among the monomers listed for the additional units on pages 15 and 16. Examples of the amino group-containing compound include the amine compounds described in JP-A 2008-111103, paragraphs [0146] to [0164] as being added to photoresist compositions. Examples of the amine salt-containing compound include salts of the foregoing amine compounds with carboxylic acids or sulfonic acids.

Suitable alcohols of at least 4 carbon atoms include 1-butyl alcohol, 2-butyl alcohol, isobutyl alcohol, tert-butyl alcohol, 1-pentanol, 2-pentanol, 3-pentanol, tert-amyl alcohol, neopentyl alcohol, 2-methyl-1-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-ethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, cyclohexanol, and 1-octanol. Suitable ether solvents of 8 to 12 carbon atoms include di-n-butyl ether, diisobutyl ether, di-sec-butyl ether, di-n-pentyl ether, diisopentyl ether, di-sec-pentyl ether, di-tert-amyl ether, and di-n-hexyl ether.

Exposure is preferably performed in an exposure dose of about 1 to 200 mJ/cm², more preferably about 10 to 100 mJ/cm². This is followed by baking (PEB) on a hot plate at 60 to 150°C for 1 to 5 minutes, preferably at 80 to 120°C for 1 to 3 minutes.

Thereafter the exposed resist film is developed in a developer consisting of an organic solvent for 0.1 to 3 minutes, preferably 0.5 to 2 minutes by any conventional techniques such as dip, puddle and spray techniques. In this way, the unexposed region of resist film was dissolved away, leaving a negative resist pattern 40 on the substrate 10 as shown in FIG. 1 (C). The developer used herein is preferably selected from among ketones such as 2-octanone, 2-nonanone, 2-heptanone, 3-heptanone, 4-heptanone, 2-hexanone, 3-hexanone, diisobutyl ketone, methylcyclohexanone, acetophenone, and methylacetophenone, and esters such as propyl acetate, butyl acetate, isobutyl acetate, amyl acetate, butenyl acetate, isoamyl acetate, propyl formate, butyl formate, isobutyl formate, amyl formate, isoamyl formate, methyl valerate, methyl pentenoate, methyl crotonate, ethyl crotonate, methyl propionate, ethyl propionate, ethyl 3-ethoxypropionate, methyl lactate, ethyl lactate, propyl lactate, butyl lactate, isobutyl lactate, amyl lactate, isoamyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate. One or more of these solvents may be used as the developer. When a mixture of plural solvents is used, they may be mixed in any desired ratio. A surfactant may be added to the developer while it may be selected from the same list of compounds as exemplified for the surfactant to be added to the resist composition.

At the end of development, the resist film is rinsed. As the rinsing liquid, a solvent which is miscible with the developer and does not dissolve the resist film is preferred. Suitable solvents include alcohols of 3 to 10 carbon atoms, ether compounds of 8 to 12 carbon atoms, alkanes, alkenes, and alkynes of 6 to 12 carbon atoms, and aromatic solvents. Specifically, suitable alkanes of 6 to 12 carbon atoms include hexane, heptane, octane, nonane, decane, undecane, dodecane, methylcyclopentane, dimethylcyclopentane, cyclohexane, methylcyclohexane, dimethylcyclohexane, cycloheptane, cyclooctane, and cyclononane. Suitable alkenes of 6 to 12 carbon atoms include hexene, heptene, octene, cyclohexene, methylcyclohexene, dimethylcyclohexene, cycloheptene, and cyclooctene. Suitable alkynes of 6 to 12 carbon atoms include hexyne, heptyne, and octyne. Suitable alcohols of 3 to 10 carbon atoms include n-propyl alcohol, isopropyl alcohol, 1-butyl alcohol, 2-butyl alcohol, isobutyl alcohol, tert-butyl alcohol, 1-pentanol, 2-pentanol, 3-pentanol, tert-amyl alcohol, neopentyl alcohol, 2-methyl-1-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-ethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, cyclohexanol, and 1-octanol. Suitable ether compounds of 8 to 12 carbon atoms include di-n-butyl ether, diisobutyl ether, di-sec-butyl ether, di-n-pentyl ether, diisopentyl ether, di-sec-pentyl ether, di-tert-amyl ether, and di-n-hexyl ether. The solvents may be used alone or in admixture. Besides the foregoing solvents, aromatic solvents may be used, for example, toluene, xylene, ethylbenzene, isopropylbenzene, tert-butylbenzene and mesitylene. Rinsing is effective for minimizing the risks of resist pattern collapse and defect formation. However, rinsing is not essential. If rinsing is omitted, the amount of solvent used may be reduced.

A hole pattern after reversal may be shrunk by the RELACS® process. A hole pattern is shrunk by coating a shrink agent thereto, and baking such that the shrink agent may undergo crosslinking at the resist surface as a result of the acid catalyst diffusing from the resist layer during bake, and the shrink agent may attach to the sidewall of the hole pattern. The bake is at a temperature of 70 to 180°C, preferably 80 to 170°C, for a time of 10 to 300 seconds. The extra shrink agent is stripped and the hole pattern is shrunk.

Where a hole pattern is formed by negative tone development, exposure by double dipole illuminations of X-and Y-direction line patterns provides the highest contrast light. The contrast may be further increased by combining dipole illumination with s-polarized illumination.

When a halftone phase shift mask bearing a lattice-like shifter pattern is used, a pattern of holes may be formed at the intersections between gratings of the lattice-like shifter pattern after development, as described in JP-A 2011-170316, paragraph [0097] (US 20110177462). The preferred halftone phase shift mask bearing a lattice-like shifter pattern has a transmittance of 3 to 15%. More preferably, the phase shift mask used is a phase shift mask including a lattice-like first shifter having a line width equal to or less than a half pitch and a second shifter arrayed on the first shifter and consisting of lines whose on-wafer size is 2 to 30 nm thicker than the line width of the first shifter, whereby a pattern of holes is formed only where the thick shifter is arrayed. Also preferably, the phase shift mask used is a phase shift mask including a lattice-like first shifter having a line width equal to or less than a half pitch and a second shifter arrayed on the first shifter and consisting of dots whose on-wafer size is 2 to 100 nm thicker than the line width of the first shifter, whereby a pattern of holes is formed only where the thick shifter is arrayed.

Exposure by double dipole illuminations of X- and Y-direction lines combined with polarized illumination presents a method of forming light of the highest contrast. This method, however, has the drawback that the throughput is substantially reduced by double exposures and mask exchange therebetween. To continuously carry out two exposures while exchanging a mask, the exposure tool must be equipped with two mask stages although the existing exposure tool includes a single mask stage. Higher throughputs may be obtained by carrying out exposure of X direction lines continuously on 25 wafers in a front-opening unified pod (FOUP), exchanging the mask, and carrying out exposure continuously on the same 25 wafers, rather than exchanging a mask on every exposure of a single wafer. However, a problem arises that as the time duration until the first one of 25 wafers is exposed in the second exposure is prolonged, the environment affects the resist such that the resist after development may change its size and shape. To block the environmental impact on wafers in standby until the second exposure, it is effective that the resist film is overlaid with a protective film.

To proceed with a single mask, it is proposed in Proc. SPIE Vol. 5377, p255 (2004) to carry out two exposures by dipole illuminations in X and Y directions using a mask bearing a lattice-like pattern. When this method is compared with the above method using two masks, the optical contrast is somewhat reduced, but the throughput is improved by the use of a single mask. The method involves forming X-direction lines in a first photoresist film by X-direction dipole illumination using a mask bearing a lattice-like pattern, insolubilizing the X-direction lines by light irradiation, coating a second photoresist film thereon, and forming Y-direction lines by Y-direction dipole illumination, thereby forming holes at the interstices between X- and Y-direction lines. Although only a single mask is needed, this method includes additional steps of insolubilizing the first photoresist pattern between the two exposures, and coating and developing the second photoresist film. Then the wafer must be removed from the exposure stage between the two exposures, giving rise to the problem of an increased alignment error. To minimize the alignment error between two exposures, two exposures must be continuously carried out without removing the wafer from the exposure stage. The addition of s-polarized illumination to dipole illumination provides a further improved contrast and is thus preferably employed. After two exposures for forming X- and Y-direction lines using a lattice-like mask are performed in an overlapping manner, negative tone development is performed whereupon a hole pattern is formed.

When it is desired to form a hole pattern via a single exposure using a lattice-like mask, a quadra-pole illumination or cross-pole illumination is used. The contrast may be improved by combining it with X-Y polarized illumination or azimuthally polarized illumination of circular polarization.

In the hole pattern forming process using the resist composition of the invention, when two exposures are involved, these exposures are carried out by changing the illumination and mask for the second exposure from those for the first exposure, whereby a fine size pattern can be formed at the highest contrast and to dimensional uniformity. The masks used in the first and second exposures bear first and second patterns of intersecting lines whereby a pattern of holes at intersections of lines is formed in the resist film after development. The first and second lines are preferably at right angles although an angle of intersection other than 90° may be employed. The first and second lines may have the same or different size and/or pitch. If a single mask bearing first lines in one area and second lines in a different area is used, it is possible to perform first and second exposures continuously. In this case, however, the maximum area available for exposure is one half. Notably, the continuous exposures lead to a minimized alignment error. Of course, the single exposure provides a smaller alignment error than the two continuous exposures.

When two exposures are performed using a single mask without reducing the exposure area, the mask pattern may be a lattice-like pattern, a dot pattern, or a combination of a dot pattern and a lattice-like pattern. The use of a lattice-like pattern contributes to the most improved light contrast, but has the drawback of a reduced resist sensitivity due to a lowering of light intensity. On the other hand, the use of a dot pattern suffers a lowering of light contrast, but provides the merit of an improved resist sensitivity.

Where holes are arrayed in horizontal and vertical directions, the above-described illumination and mask pattern are used. Where holes are arrayed at a different angle, for example, at an angle of 45°, a mask of a 45° arrayed pattern is combined with dipole illumination or cross-pole illumination.

Where two exposures are performed, a first exposure by a combination of dipole illumination with polarized illumination for enhancing the contrast of X-direction lines is followed by a second exposure by a combination of dipole illumination with polarized illumination for enhancing the contrast of Y-direction lines. Two continuous exposures with the X- and Y-direction contrasts emphasized through a single mask can be performed on a currently commercially available scanner.

The method of combining X and Y polarized illuminations with cross-pole illumination using a mask bearing a lattice-like pattern can form a hole pattern through a single exposure, despite a slight lowering of light contrast as compared with two exposures of dipole illumination. The method is estimated to attain a substantial improvement in throughput and avoids the problem of misalignment between two exposures. Using such a mask and illumination, a hole pattern of the order of 40 nm can be formed at a practically acceptable cost.

On use of a mask bearing a lattice-like pattern, light is fully shielded at intersections between gratings. A fine hole pattern may be formed by performing exposure through a mask bearing such a pattern and organic solvent development entailing positive/negative reversal.

On use of a mask bearing a dot pattern, although the contrast of an optical image is low as compared with the lattice-like pattern mask, the formation of a hole pattern is possible owing to the presence of black or light shielded spots.

It is difficult to form a fine hole pattern that holes are randomly arrayed at varying pitch and position. The super-resolution technology using off-axis illumination (such as dipole or cross-pole illumination) in combination with a phase shift mask and polarization is successful in improving the contrast of dense (or grouped) patterns, but not so the contrast of isolated patterns.

When the super-resolution technology is applied to repeating dense patterns, the pattern density bias between dense and isolated patterns, known as proximity bias, becomes a problem. As the super-resolution technology used becomes stronger, the resolution of a dense pattern is more improved, but the resolution of an isolated pattern remains unchanged. Then the proximity bias is exaggerated. In particular, an increase of proximity bias in a hole pattern resulting from further miniaturization poses a serious problem. One common approach taken to suppress the proximity bias is by biasing the size of a mask pattern. Since the proximity bias varies with properties of a photoresist composition, specifically dissolution contrast and acid diffusion, the proximity bias of a mask varies with the type of photoresist composition. For a particular type of photoresist composition, a mask having a different proximity bias must be used. This adds to the burden of mask manufacturing. Then the pack and unpack (PAU) method is proposed in Proc. SPIE Vol. 5753, p171 (2005), which involves strong super-resolution illumination of a first positive resist to resolve a dense hole pattern, coating the first positive resist pattern with a negative resist film material in alcohol solvent which does not dissolve the first positive resist pattern, exposure and development of an unnecessary hole portion to close the corresponding holes, thereby forming both a dense pattern and an isolated pattern. One problem of the PAU method is misalignment between first and second exposures, as the authors point out in the report. The hole pattern which is not closed by the second development experiences two developments and thus undergoes a size change, which is another problem.

To form a random pitch hole pattern by organic solvent development entailing positive/negative reversal, a mask is used in which a lattice-like pattern is arrayed over the entire surface and the width of gratings is thickened only where holes are to be formed as described in JP-A 2011-170316, paragraph [0102].

Also useful is a mask in which a lattice-like pattern is arrayed over the entire surface and thick dots are disposed only where holes are to be formed.

On use of a mask bearing no lattice-like pattern arrayed, holes are difficult to form, or even if holes are formed, a variation of mask size is largely reflected by a variation of hole size because the optical image has a low contrast.

### EXAMPLE

Examples of the invention are given below by way of illustration and not by way of limitation. The abbreviation "pbw" is parts by weight. For all polymers, Mw and Mn are determined by GPC versus polystyrene standards using tetrahydrofuran solvent.

### Polymers (composition, Mw and Mw/Mn)

Table 1 is a list of polymers used herein, with their compositional ratio (mol%) of recurring units, molecular weight (Mw) and dispersity (Mw/Mn) shown. Tables 2 and 3 show the structure of recurring units. It is noted that Lac-1 and Lac-2 in Table 2 are lactone-containing recurring units essential for polymers to be used in negative resist compositions within the scope of the invention. Accordingly, Polymer-1 to Polymer-19 are within the scope of the invention whereas Polymer-20 to Polymer-27 are comparative polymers.

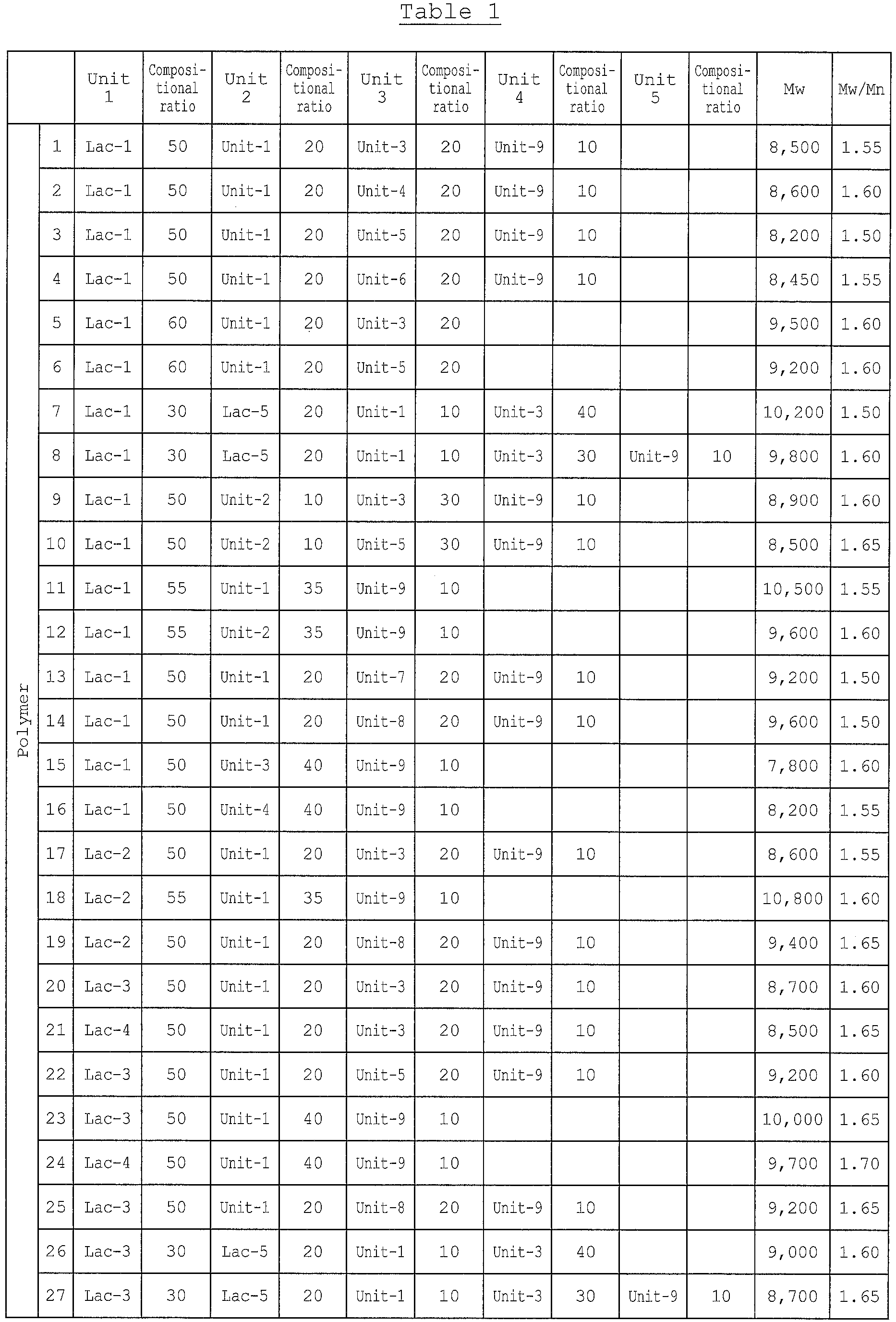

**Table 2**

| Lac-1 | Lac-2 | Lac-3 | Lac-4 | Lac-5 |
|---|---|---|---|---|
| 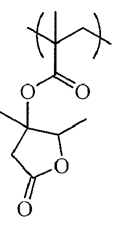 | 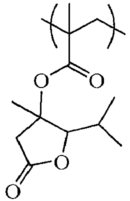 | 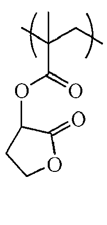 | 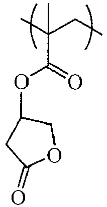 | 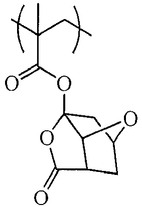 |

**Table 3**

| | | |
|---|---|---|
| Unit-1 | Unit-2 | Unit-3 |
| 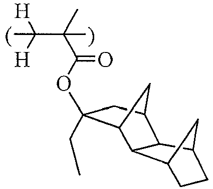 | 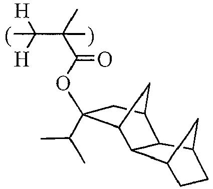 | 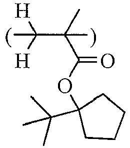 |
| Unit-4 | Unit-5 | Unit-6 |
| 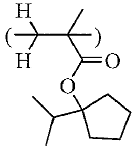 | 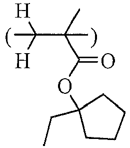 | 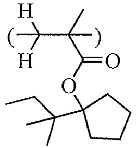 |
| Unit-7 | Unit-8 | Unit-9 |
| 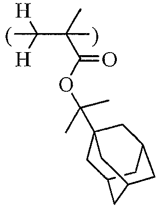 | 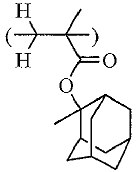 | 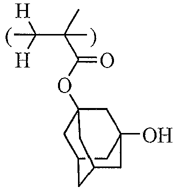 |

### Preparation of resist composition

Resist compositions in solution form within the scope of the invention were prepared by dissolving a polymer (in Table 1) and components in a solvent in accordance with the formulation of Table 4 and filtering through a Teflon® filter with a pore size of 0.2 µm. For comparison, resist compositions were similarly prepared in accordance with the formulation of Table 5. The structure of photoacid generator (PAG-1 to 5) is shown in Table 6, and the structure of quencher (A-1 to 5) is shown in Table 7. It is noted that PAG-1 and PAG-2 in Table 6 are essential in negative resist compositions within the scope of the invention.

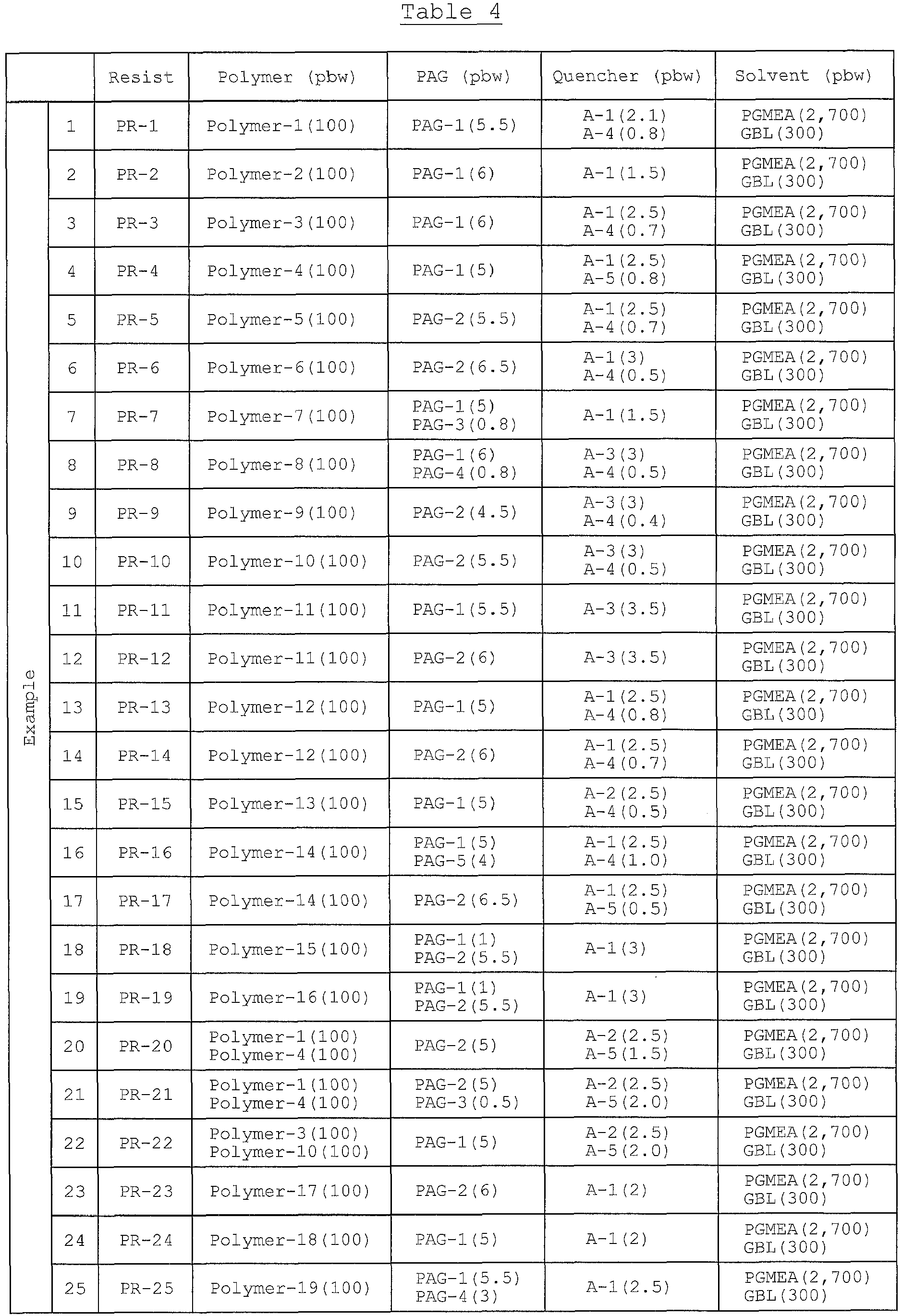

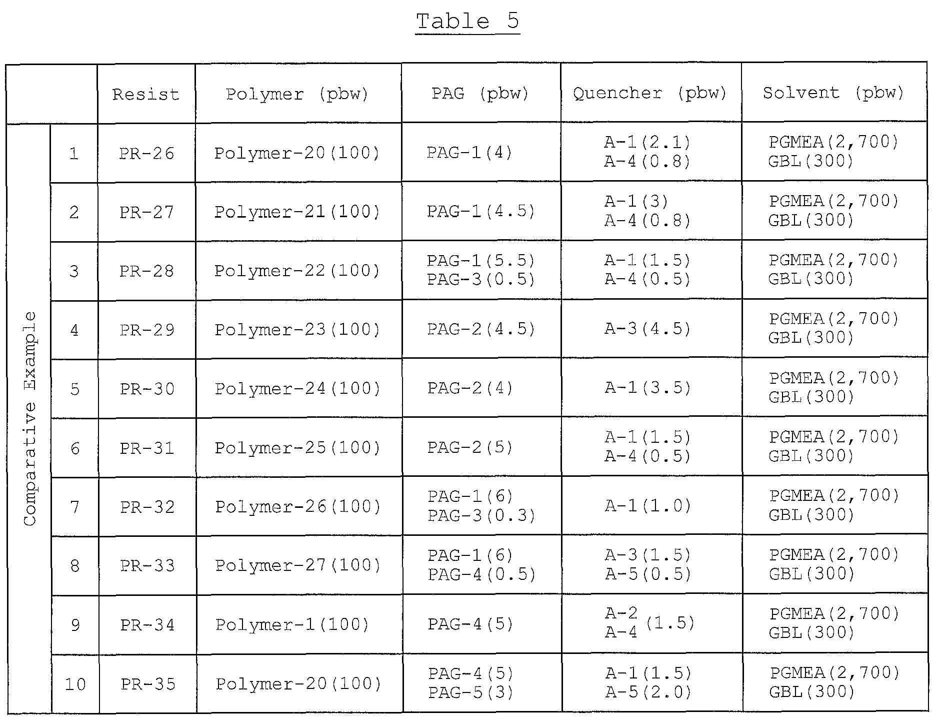

**Table 6**

| | |
|---|---|
| PAG-1 | PAG-2 |
| 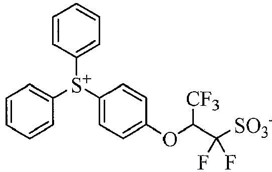 | 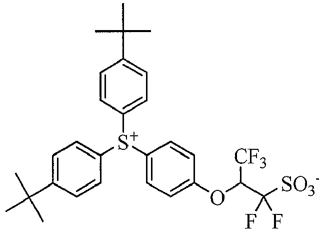 |
| PAG-3 | PAG-4 |
| 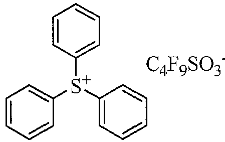 | 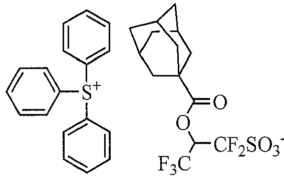 |
| PAG-5 | |
| 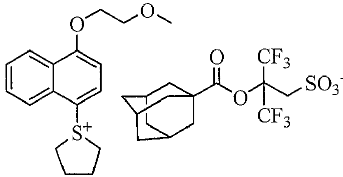 | |

**Table 7**

| | |
|---|---|
| A-1 | A-2 |
| 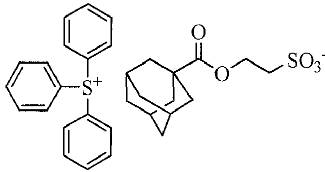 | 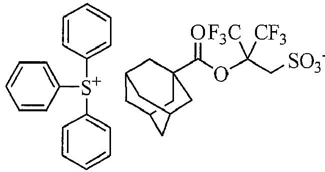 |
| A-3 | A-4 |
| 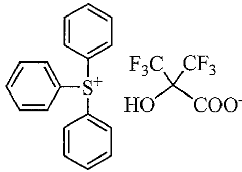 | 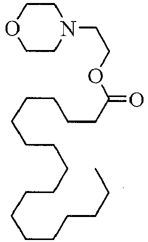 |
| A-5 | |
| 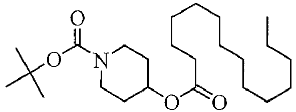 | |

The organic solvents in Tables 4 and 5 are PGMEA (propylene glycol monomethyl ether acetate) and GBL (γ-butyrolactone).

To the resist compositions in Tables 4 and 5 were added 5.0 pbw of Alkali-soluble surfactant SF-1 and 0.1 pbw of Surfactant A, as shown below.

### Alkali-soluble surfactant SF-1:

### poly(2,2,3,3,4,4,4-heptafluoro-1-isobutyl-1-butyl methacrylate/9-(2,2,2-trifluoro-1-trifluoroethyloxy-carbonyl)-4-oxatricyclo[4.2.1.0^{3,7}]nonan-5-on-2-yl methacrylate)

Mw = 8,200
Mw/Mn = 1.44

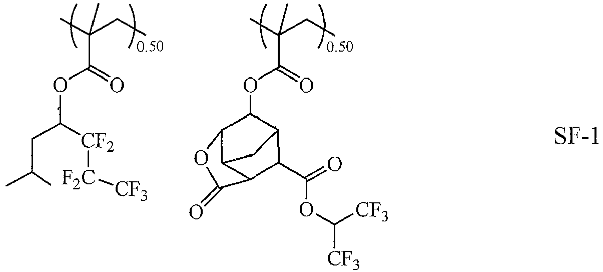

### Surfactant A:

### 3-methyl-3-(2,2,2-trifluoroethoxymethyl)oxetane/ tetrahydrofuran/2,2-dimethyl-1,3-propane diol copolymer (Omnova Solutions, Inc.)

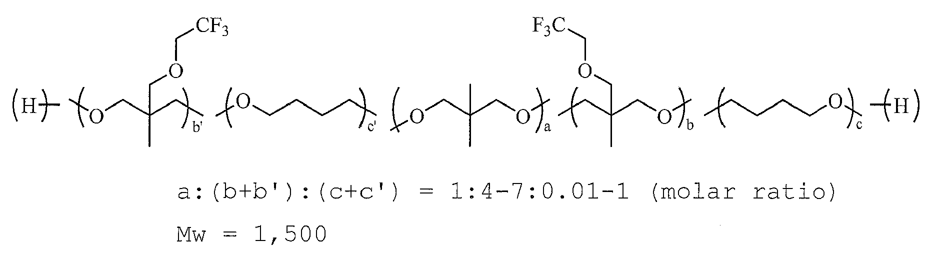

a:(b+b'):(c+c') = 1:4-7:0.01-1 (molar ratio)
Mw = 1,500

### Lithography test

On a substrate (silicon wafer), a spin-on carbon film ODL-50 (Shin-Etsu Chemical Co., Ltd.) having a carbon content of 100 wt% was deposited to a thickness of 200 nm and a silicon-containing spin-on hard mask SHB-A940 having a silicon content of 43 wt% was deposited thereon to a thickness of 35 nm. On this substrate for trilayer process, the resist composition shown in Tables 4 and 5 was spin coated, then baked on a hot plate at 100°C for 60 seconds to form a resist film of 90 nm thick. Using an ArF excimer laser immersion lithography scanner NSR-610C (Nikon Corp., NA 1.30, σ 0.9/0.72, cross-pole opening 35 deg., azimuthally polarized illumination), exposure was performed in a varying dose through a 6% halftone phase shift mask. After the exposure, the wafer was baked (PEB) at the temperature shown in Tables 8 and 9 for 60 seconds and developed. Specifically, the developer shown in Tables 8 and 9 was injected from a development nozzle while the wafer was spun at 30 rpm for 3 seconds, which was followed by stationary puddle development for 27 seconds. The wafer was rinsed with 4-methyl-2-pentanol, spin dried, and baked at 100°C for 20 seconds to evaporate off the rinse liquid, yielding a hole pattern having a pitch of 100 nm and a hole diameter of 50 nm.

The hole pattern thus formed was observed under a top-down scanning electron microscope (TDSEM) CG-4000 (Hitachi High-Technologies Corp.). The diameter of 125 holes was measured, from which a 3-fold value (3σ) of standard deviation (σ) was determined and reported as hole size variation. A smaller value of 3σ indicates a pattern having a multiplicity of holes with a less size variation. Also under SEM observation, the distance from the center to the periphery of 25 holes was measured in 24 directions, from which a 3-fold value (3σ) of standard deviation (σ) was determined and reported as roundness. A smaller value of 3σ indicates holes with higher roundness. The resist compositions within the scope of the invention form patterns having improved dimensional uniformity and roundness after organic solvent development.

For the resist compositions within the scope of the invention in Table 4, the PEB temperature and developer are shown in Table 8 together with the test results. For the comparative resist compositions in Table 5, the PEB temperature and developer are shown in Table 9 together with the test results.

**Table 8**

| | | Resist | PEB temp. (°C) | Developer | Hole size variation (nm) | Roundness (nm) |
|---|---|---|---|---|---|---|
| | 1 | PR-1 | 90 | n-butyl acetate | 3.7 | 1.9 |
| | 2 | PR-2 | 90 | n-butyl acetate | 4.0 | 2.1 |
| | 3 | PR-3 | 95 | n-butyl acetate | 3.5 | 2.0 |
| | 4 | PR-4 | 85 | n-butyl acetate | 3.6 | 1.8 |
| | 5 | PR-5 | 80 | n-butyl acetate | 3.7 | 1.9 |
| | 6 | PR-6 | 90 | n-butyl acetate | 3.8 | 1.9 |
| | 7 | PR-7 | 100 | n-butyl acetate | 3.7 | 1.8 |
| | 8 | PR-8 | 90 | n-butyl acetate | 3.6 | 1.9 |
| | 9 | PR-9 | 90 | n-butyl acetate | 4.1 | 2.1 |
| | 10 | PR-10 | 95 | 2-heptanone | 3.6 | 2.2 |
| | 11 | PR-11 | 95 | methyl benzoate | 3.9 | 1.9 |
| | 12 | PR-12 | 95 | ethyl benzoate | 4.0 | 2.0 |
| Example | 13 | PR-13 | 90 | n-butyl acetate | 3.5 | 1.8 |
| | 14 | PR-14 | 90 | methyl benzoate | 3.7 | 1.7 |
| | 15 | PR-15 | 95 | n-butyl acetate | 3.6 | 1.9 |
| | 16 | PR-16 | 95 | n-butyl acetate | 3.5 | 1.9 |
| | 17 | PR-17 | 85 | n-butyl acetate | 3.6 | 1.9 |
| | 18 | PR-18 | 90 | n-butyl acetate | 3.4 | 1.7 |
| | 19 | PR-19 | 95 | n-butyl acetate | 3.5 | 1.8 |
| | 20 | PR-20 | 100 | n-butyl acetate | 3.3 | 1.8 |
| | 21 | PR-21 | 85 | n-butyl acetate | 3.6 | 2.2 |
| | 22 | PR-22 | 95 | n-butyl acetate | 4.0 | 2.0 |
| | 23 | PR-23 | 90 | methyl benzoate | 3.9 | 1.9 |
| | 24 | PR-24 | 95 | ethyl benzoate | 3.8 | 1.8 |
| | 25 | PR-25 | 90 | n-butyl acetate | 3.9 | 1.9 |

**Table 9**

| | | Resist | PEB temp. (°C) | Developer | Hole size variation (nm) | Roundness (nm) |
|---|---|---|---|---|---|---|
| | 1 | PR-26 | 90 | n-butyl acetate | 5.1 | 2.8 |
| | 2 | PR-27 | 90 | n-butyl acetate | 4.8 | 2.6 |
| | 3 | PR-28 | 95 | n-butyl acetate | 5.8 | 2.9 |
| | 4 | PR-29 | 85 | n-butyl acetate | 5.0 | 2.7 |
| Comparative Example | 5 | PR-30 | 90 | n-butyl acetate | 4.9 | 2.6 |
| | 6 | PR-31 | 100 | n-butyl acetate | 4.8 | 2.7 |
| | 7 | PR-32 | 90 | 2-heptanone | 5.3 | 2.7 |
| | 8 | PR-33 | 85 | methyl benzoate | 5.9 | 3.0 |
| | 9 | PR-34 | 95 | n-butyl acetate | 4.6 | 3.1 |
| | 10 | PR-35 | 90 | n-butyl acetate | 5.1 | 2.7 |

It is evident from Tables 8 and 9 that the process for forming a negative pattern by coating a resist composition comprising a polymer comprising recurring units of formula (1) and a PAG of formula (2) onto a substrate, baking the composition to form a resist film, exposing the resist film to high-energy radiation, PEB, and developing in an organic solvent developer to form a negative pattern wherein the unexposed region of resist film is dissolved and the exposed region of resist film is not dissolved, is successful in forming hole patterns having minimized dimensional variation and improved roundness, as demonstrated by Examples 1 to 25.

While the invention has been illustrated and described in typical embodiments, it is not intended to be limited to the details shown, since various modifications and substitutions can be made without departing in any way from the spirit of the present invention. As such, further modifications and equivalents of the invention herein disclosed may occur to persons skilled in the art using no more than routine experimentation, and all such modifications and equivalents are believed to be within the spirit and scope of the invention as defined by the following claims.

Japanese Patent Application No. 2014-110532 is incorporated herein by reference.

Although some preferred embodiments have been described, many modifications and variations may be made thereto in light of the above teachings. It is therefore to be understood that the invention may be practiced otherwise than as specifically described without departing from the scope of the appended claims.

## Claims

1. A resist composition comprising (A) a resin component comprising recurring units having the general formula (1) and (B) a photoacid generator having the general formula (2): 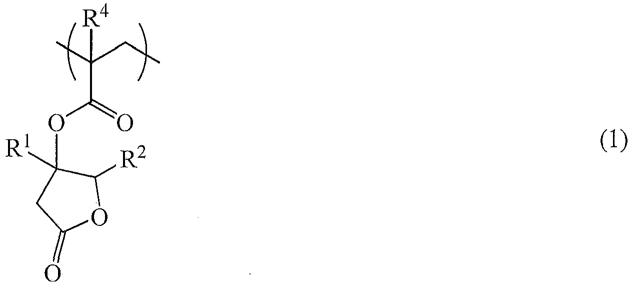 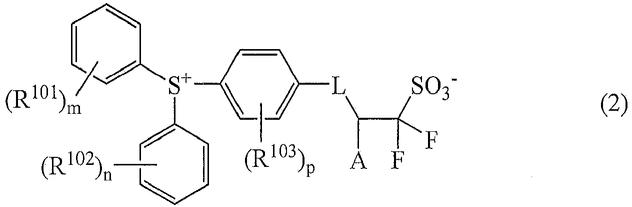 wherein R¹ and R² are each independently C₁-C₃ alkyl, R⁴ is hydrogen or methyl, A is hydrogen or trifluoromethyl, R¹⁰¹, R¹⁰² and R¹⁰³ are each independently hydrogen or a straight, branched or cyclic C₁-C₂₀ monovalent hydrocarbon group, optionally substituted with heteroatoms, which may be linked to the phenyl ring by a heteroatom, m and n each are an integer of 0 to 5, p is an integer of 0 to 4, and L is a single bond, an oxygen atom or a straight, branched or cyclic C₁-C₂₀ divalent hydrocarbon group which may be substituted with a heteroatom.

2. The resist composition of claim 1 wherein the resin component (A) further comprises recurring units having the general formula (3): 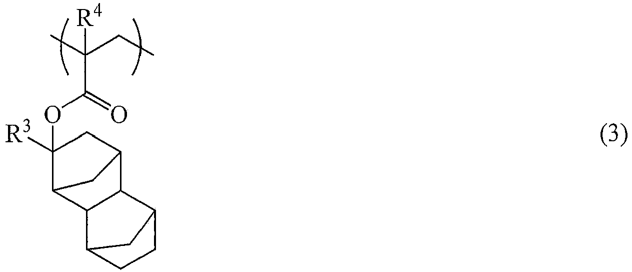 wherein R³ is straight or branched C₁-C₄ alkyl, and R⁴ is hydrogen or methyl.

3. The resist composition of claim 1 or 2 wherein the resin component (A) further comprises recurring units having the general formula (4): 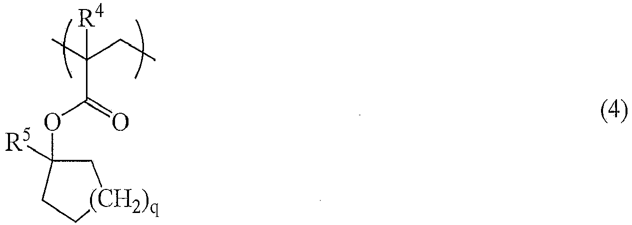 wherein R⁵ is straight or branched C₁-C₆ alkyl, R⁴ is hydrogen or methyl, and q is 1 or 2.

4. The resist composition of any one of claims 1 to 3, further comprising (Z) a sulfonium salt of sulfonic acid or carboxylic acid having the general formula (Z1) or (Z2): 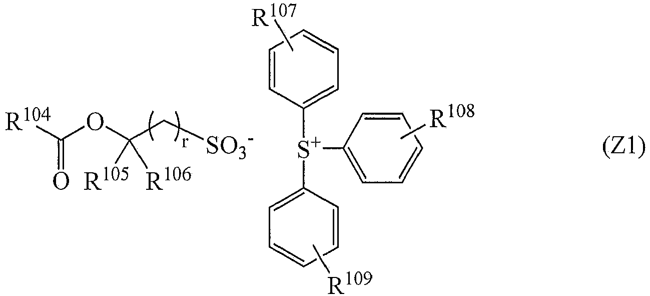 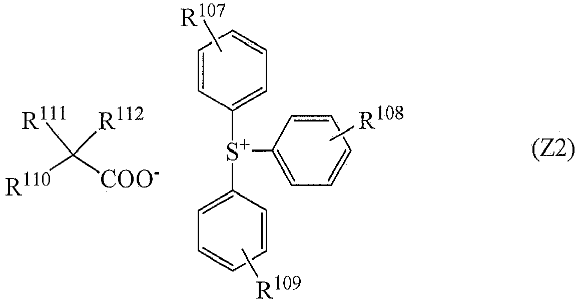 wherein R¹⁰⁵, R¹⁰⁶, R¹¹¹, and R¹¹² are hydrogen or trifluoromethyl, R¹⁰⁴ is a straight, branched or cyclic C₁-C₃₅ monovalent hydrocarbon group which may contain an oxygen atom, r is an integer of 0 to 3, R¹¹⁰ is hydrogen, hydroxyl, a straight, branched or cyclic C₁-C₃₅ monovalent hydrocarbon group which may contain an oxygen atom, or a substituted or unsubstituted C₆-C₃₀ aryl group, R¹⁰⁷, R¹⁰⁸, and R¹⁰⁹ are each independently hydrogen, a substituted or unsubstituted, straight or branched C₁-C₁₀ alkyl, alkenyl or oxoalkyl group, or a substituted or unsubstituted C₆-C₁₈ aryl, aralkyl or aryloxoalkyl group, or any two or more of R¹⁰⁷, R¹⁰⁸, and R¹⁰⁹ may bond together to form a ring with the sulfur atom.

5. A process for forming a pattern, comprising the steps of applying a resist composition comprising (A) a resin component comprising recurring units having the general formula (1) and (B) a photoacid generator having the general formula (2) onto a substrate, baking the composition to form a resist film, exposing the resist film to high-energy radiation to define exposed and unexposed regions, baking, and applying an organic solvent developer to form a negative pattern wherein the unexposed region of resist film is dissolved and the exposed region of resist film is not dissolved, 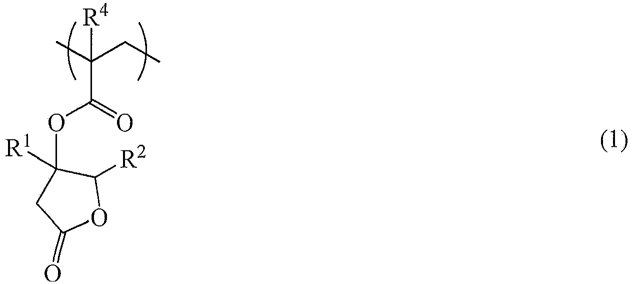 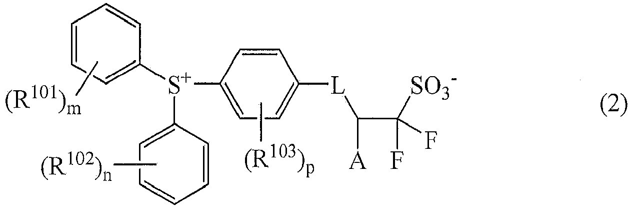 wherein R¹ and R² are each independently C₁-C₃ alkyl, R⁴ is hydrogen or methyl, A is hydrogen or trifluoromethyl, R¹⁰¹, R¹⁰² and R¹⁰³ are each independently hydrogen or a straight, branched or cyclic C₁-C₂₀ monovalent hydrocarbon group, optionally substituted with heteroatoms, which may be linked to the phenyl ring by a heteroatom, m and n each are an integer of 0 to 5, p is an integer of 0 to 4, and L is a single bond, an oxygen atom or a straight, branched or cyclic C₁-C₂₀ divalent hydrocarbon group which may be substituted with a heteroatom.

6. The process of claim 5 wherein the resin component (A) further comprises recurring units having the general formula (3) : 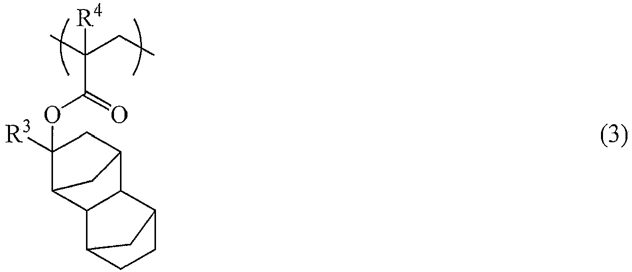 wherein R³ is straight or branched C₁-C₄ alkyl, and R⁴ is hydrogen or methyl.

7. The process of claim 5 or 6 wherein the resin component (A) further comprises recurring units having the general formula (4): 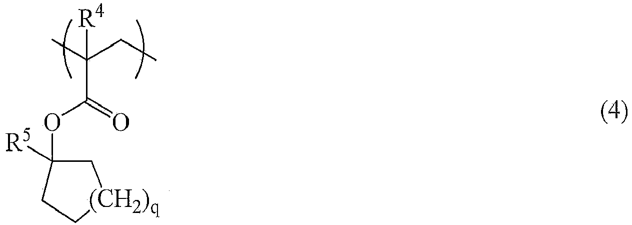 wherein R⁵ is straight or branched C₁-C₆ alkyl, R⁴ is hydrogen or methyl, and q is 1 or 2.

8. The process of any one of claims 5 to 7, wherein the resist composition further comprises (Z) a sulfonium salt of sulfonic acid or carboxylic acid having the general formula (Z1) or (Z2): 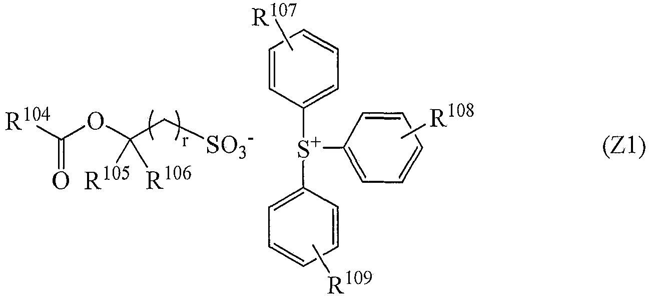 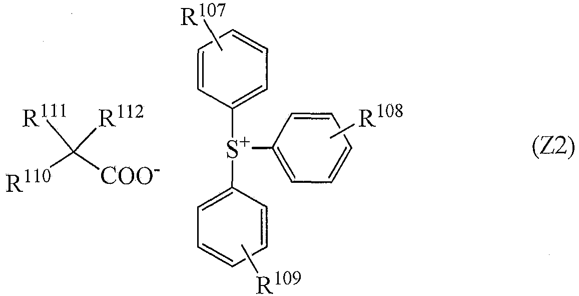 wherein R¹⁰⁵, R¹⁰⁶, R¹¹¹, and R¹¹² are hydrogen or trifluoromethyl, R¹⁰⁴ is a straight, branched or cyclic C₁-C₃₅ monovalent hydrocarbon group which may contain an oxygen atom, r is an integer of 0 to 3, R¹¹⁰ is hydrogen, hydroxyl, a straight, branched or cyclic C₁-C₃₅ monovalent hydrocarbon group which may contain an oxygen atom, or a substituted or unsubstituted C₆-C₃₀ aryl group, R¹⁰⁷, R¹⁰⁸, and R¹⁰⁹ are each independently hydrogen, a substituted or unsubstituted, straight or branched C₁-C₁₀ alkyl, alkenyl or oxoalkyl group, or a substituted or unsubstituted C₆-C₁₈ aryl, aralkyl or aryloxoalkyl group, or any two or more of R¹⁰⁷, R¹⁰⁸, and R¹⁰⁹ may bond together to form a ring with the sulfur atom.

9. The process of any one of claims 5 to 8 wherein the developer comprises at least one organic solvent selected from the group consisting of 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, amyl acetate, isoamyl acetate, butenyl acetate, propyl formate, butyl formate, isobutyl formate, amyl formate, isoamyl formate, methyl valerate, methyl pentenoate, methyl crotonate, ethyl crotonate, methyl propionate, ethyl propionate, ethyl 3-ethoxypropionate, methyl lactate, ethyl lactate, propyl lactate, butyl lactate, isobutyl lactate, amyl lactate, isoamyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate.

10. The process of any one of claims 5 to 9 wherein the step of exposing the resist film to high-energy radiation includes KrF excimer laser lithography of wavelength 248 nm, ArF excimer laser lithography of wavelength 193 nm, EUV lithography of wavelength 13.5 nm or EB lithography.

## Patentansprüche

1. Resistzusammensetzung, umfassend (A) eine Resistkomponente, umfassend wiederkehrende Einheiten mit der allgemeinen Formel (1) und (B) einen Fotosäuregenerator mit der allgemeinen Formel (2): 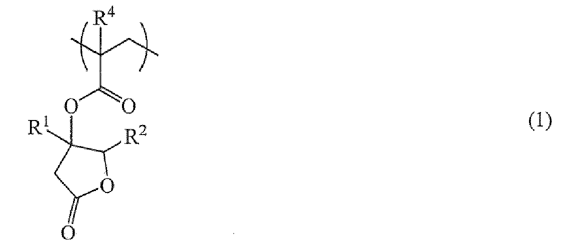 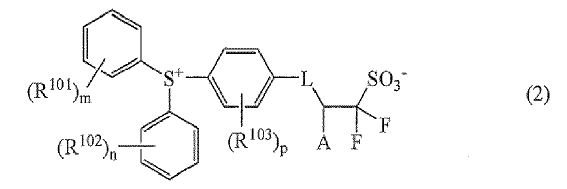 worin R¹ und R² jeweils unabängig C₁-C₃-Alkyl sind, R⁴ Wasserstoff oder Methyl ist, A Wasserstoff oder Trifluormethyl ist, R¹⁰¹, R¹⁰² und R¹⁰³ jeweils unabhängig Wasserstoff oder eine gerade, verzweigte oder cyclische, einwertige C₁-C₂₀-Kohlenwasserstoffgruppe sind, wahlweise substituiert mit Heteroatomen, die an den Phenylring durch ein Heteroatom gebunden sein können, m und n jeweils eine ganze Zahl von 0 bis 5 sind, p eine ganze Zahl von 0 bis 4 ist, und L eine Einfachbindung, ein Sauerstoffatom oder eine gerade, verzweigte oder cyclische, zweiwertige C₁-C₂₀-Kohlenwasserstoffgruppe ist, die mit einem Heteroatom substituiert sein kann.

2. Resistzusammensetzung nach Anspruch 1, wobei die Harzkomponente (A) weiterhin wiederkehrende Einheiten mit der allgemeinen Formel (3) umfasst: 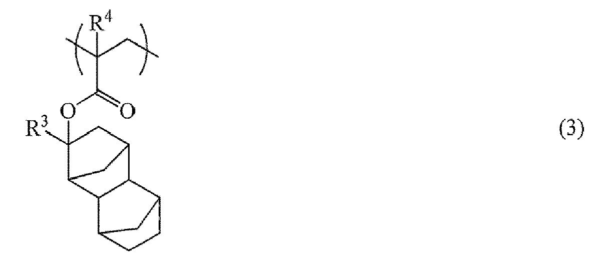 worin R³ gerades oder verzweigtes C₁-C₄-Alkyl ist, und R⁴ Wasserstoff oder Methyl ist.

3. Resistzusammensetzung nach Anspruch 1 oder 2, wobei die Harzkomponente (A) weiterhin wiederkehrende Einheiten mit der allgemeinen Formel (4) umfasst: 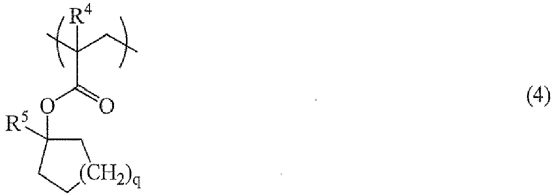 worin R⁵ gerades oder verzweigtes C₁-C₆-Alkyl ist, R⁴ Wasserstoff oder Methyl ist, und q 1 oder 2 ist.

4. Resistzusammensetzung nach mindestens einem der Ansprüche 1 bis 3, weiterhin umfassend (Z) ein Sulfoniumsalz von Sulfonsäure oder Carbonsäure mit der allgemeinen Formel (Z1) oder (Z2): 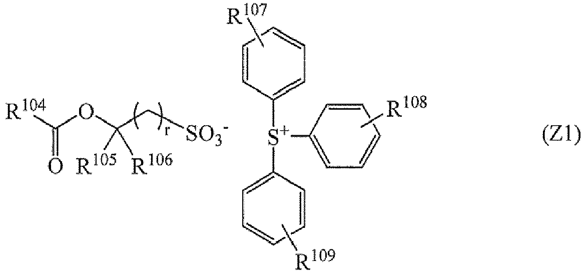 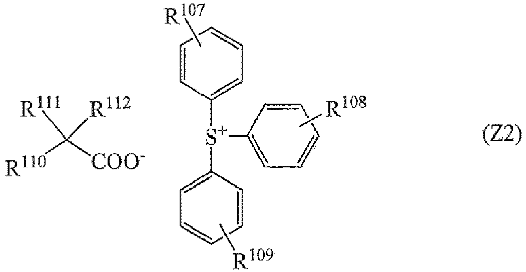 worin R¹⁰⁵, R¹⁰⁶, R¹¹¹ und R¹¹² Wasserstoff oder Trifluormethyl sind, R¹⁰⁴ eine gerade, verzweigte oder cyclische, einwertige C₁-C₃₅-Kohlenwasserstoffgruppe ist, welche ein Sauerstoffatom enthalten kann, r eine ganze Zahl von 0 bis 3 ist, R¹¹⁰ Wasserstoff, Hydroxyl, eine gerade, verzweigte oder cyclische, einwertige C₁-C₃₅-Kohlenwasserstoffgruppe ist, welche ein Sauerstoffatom enthalten kann, oder eine subsituierte oder unsubstituierte C₆-C₃₀-Arylgruppe, R¹⁰⁷, R¹⁰⁸ und R¹⁰⁹ jeweils unabhängig Wasserstoff, eine subsituierte oder unsubstituierte, gerade oder verzweigte C₁-C₁₀-Alkyl-, -Alkenyl- oder -Oxyalkylgruppe, oder eine substituierte oder unsubstituierte C₆-C₁₈-Aryl-, -Aralkyl- oder -Aryloxyalkylgruppe sind, oder beliebige zwei oder mehrere von R¹⁰⁷, R¹⁰⁸ und R¹⁰⁹ miteinander verbunden sein können, um mit dem Schwefelatom einen Ring zu bilden.

5. Verfahren zur Herstellung eines Musters, umfassend die Schritte des Aufbringens einer Resistzusammensetzung, umfassend (A) eine Harzkomponente, umfassend wiederkehrende Einheiten mit der allgemeinen Formel (1) und (B) einen Fotosäuregenerator mit der allgemeinen Formel (2) auf ein Substrat, thermisches Behandeln der Zusammensetzung zur Bildung eines Resistfilms, Aussetzen des Resistfilms gegenüber Hochenergiestrahlung, um belichtete und nichtbelichtete Bereiche zu definieren, thermisches Behandeln und Aufbringen eines organischen Lösungsmittelentwicklers, um ein negatives Muster zu bilden, wobei der unbelichtete Bereich des Resistfilms gelöst wird und der belichtete Bereich des Resistfilms nicht gelöst wird, 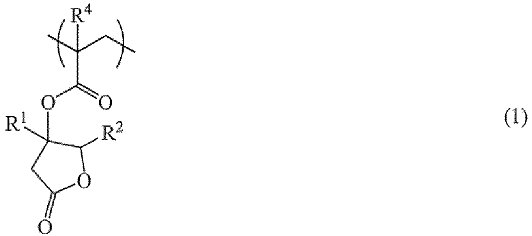 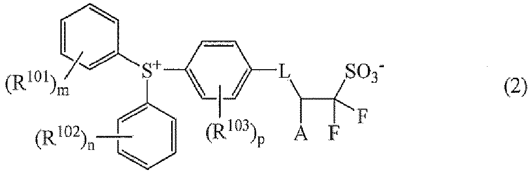 worin R¹ und R² jeweils unabängig C₁-C₃-Alkyl sind, R⁴ Wasserstoff oder Methyl ist, A Wasserstoff oder Trifluormethyl ist, R¹⁰¹, R¹⁰² und R¹⁰³ jeweils unabhängig Wasserstoff oder eine gerade, verzweigte oder cyclische, einwertige C₁-C₂₀-Kohlenwasserstoffgruppe sind, wahlweise substituiert mit Heteroatomen, die an den Phenylring durch ein Heteroatom gebunden sein können, m und n jeweils eine ganze Zahl von 0 bis 5 sind, p eine ganze Zahl von 0 bis 4 ist, und L eine Einfachbindung, ein Sauerstoffatom oder eine gerade, verzweigte oder cyclische, zweiwertige C₁-C₂₀-Kohlenwasserstoffgruppe ist, die mit einem Heteroatom substituiert sein kann.

6. Verfahren nach Anspruch 5, wobei die Harzkomponente (A) weiterhin wiederkehrende Einheiten mit der allgemeinen Formel (3) umfasst: 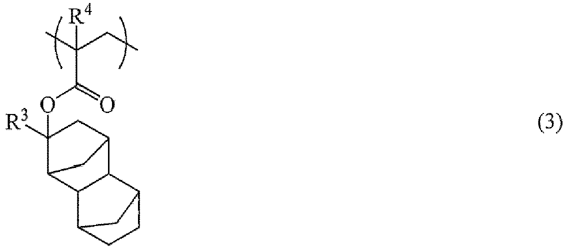 worin R³ gerades oder verzweigtes C₁-C₄-Alkyl ist, und R⁴ Wasserstoff oder Methyl ist.

7. Verfahren nach Anspruch 5 oder 6, wobei die Harzkomponente (A) weiterhin wiederkehrende Einheiten mit der allgemeinen Formel (4) umfasst: 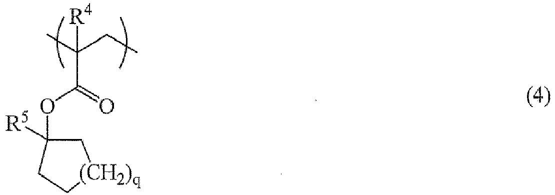 worin R⁵ gerades oder verzweigtes C₁-C₆-Alkyl ist, R⁴ Wasserstoff oder Methyl ist, und q 1 oder 2 ist.

8. Verfahren nach mindestens einem der Ansprüche 5 bis 7, wobei die Resistzusammenseztung weiterhin (Z) ein Sulfoniumsalz von Sulfonsäure oder Carbonsäure mit der allgemeinen Formel (Z1) oder (Z2) umfasst: 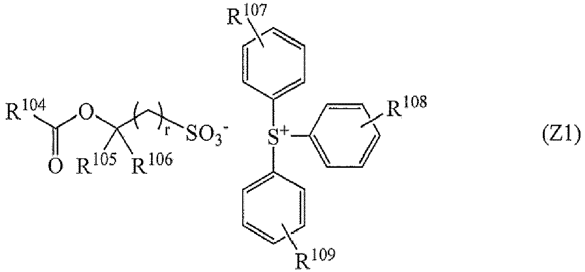 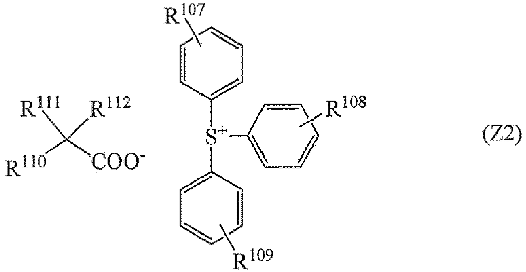 worin R¹⁰⁵, R¹⁰⁶, R¹¹¹ und R¹¹² Wasserstoff oder Trifluormethyl sind, R¹⁰⁴ eine gerade, verzweigte oder cyclische, einwertige C₁-C₃₅-Kohlenwasserstoffgruppe ist, welche ein Sauerstoffatom enthalten kann, r eine ganze Zahl von 0 bis 3 ist, R¹¹⁰ Wasserstoff, Hydroxyl, eine gerade, verzweigte oder cyclische, einwertige C₁-C₃₅-Kohlenwasserstoffgruppe ist, welche ein Sauerstoffatom enthalten kann, oder eine subsituierte oder unsubstituierte C₆-C₃₀-Arylgruppe, R¹⁰⁷, R¹⁰⁸ und R¹⁰⁹ jeweils unabhängig Wasserstoff, eine subsituierte oder unsubstituierte, gerade oder verzweigte C₁-C₁₀-Alkyl-, -Alkenyl- oder -Oxyalkylgruppe, oder eine substituierte oder unsubstituierte C₆-C₁₈-Aryl-, -Aralkyl- oder -Aryloxyalkylgruppe sind, oder beliebige zwei oder mehrere von R¹⁰⁷, R¹⁰⁸ und R¹⁰⁹ miteinander verbunden sein können, um mit dem Schwefelatom einen Ring zu bilden.

9. Verfahren nach mindestens einem der Ansprüche 5 bis 8, wobei der Entwickler mindestens ein organisches Lösungsmittel umfasst, gewählt aus der Gruppe, bestehend aus 2-Octanon, 2-Nonanon, 2-Heptanon, 3-Heptanon, 4-Heptanon, 2-Hexanon, 3-Hexanon, Diisobutylketon, Methylcyclohexanon, Acetophenon, Methylacetophenon, Propylacetat, Butylacetat, Isobutylacetat, Amylacetat, Isoamylacetat, Butenylacetat, Propylformiat, Butylformiat, Isobutylformiat, Amylformiat, Isoamylformiat, Methylvalerat, Methylpentenoat, Methylcrotonat, Ethylcrotonat, Methylpropionat, Ethylpropionat, Ethyl-3-ethoxypropionat, Methyllactat, Ethyllactat, Propyllactat, Butyllactat, Isobutyllactat, Amyllactat, Isoamyllactat, Methyl 2-hydroxyisobutyrat, Ethyl-2-hydroxyisobutyrat, Methylbenzoat, Ethylbenzoat, Phenylacetat, Benzylacetat, Methylphenylacetat, Benzylformiat, Phenylethylformiat, Methyl-3-phenylpropionat, Benzylpropionat, Ethylphenylacetat und 2-Phenylethylacetat.

10. Verfahren nach mindestens einem der Ansprüche 5 bis 9, wobei der Schritt des Aussetzens des Resistfilms gegenüber Hochenergiestrahlung KrF-Excimer-Laser-Lithographie der Wellenlänge 248 nm, ArF-Excimer-Laser-Lithographie der Wellenlänge 193 nm, EUV-Lithographie der Wellenlänge 13,5 nm oder EB-Lithographie beinhaltet.

## Revendications

1. Une composition de réserve comprenant (A) un composant de résine comprenant des unités récurrentes ayant la formule générale (1) et (B) un générateur de photoacide ayant la formule générale (2): 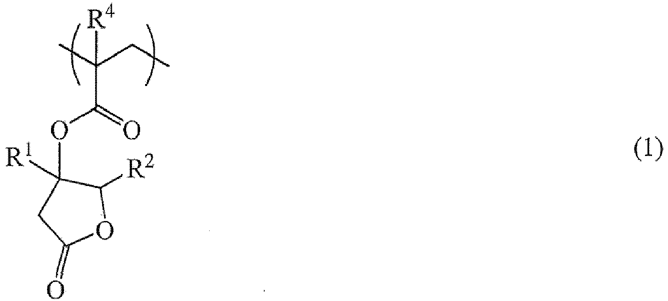 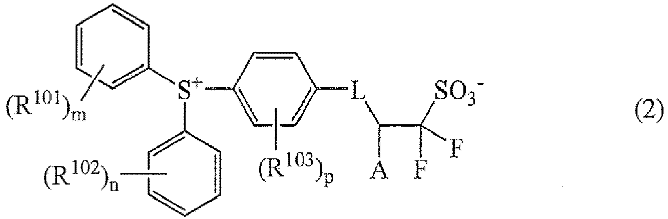 dans lesquelles R¹ et R² sont chacun indépendamment un alkyle en C₁-C₃, R⁴ est de l'hydrogène ou du méthyle, A est de l'hydrogène ou du trifluorométhyle, R¹⁰¹, R¹⁰² et R¹⁰³ sont chacun indépendamment de l'hydrogène ou un groupe hydrocarboné monovalent en C₁-C₂₀ linéaire, ramifié ou cyclique, facultativement substitué par des hétéroatomes, qui peut être lié à l'anneau de phényle par un hétéroatome, m et n
sont chacun un nombre entier de 0 à 5, p est un nombre entier de 0 à 4, et L est une liaison simple, un atome d'oxygène ou un groupe hydrocarboné divalent en C₁-C₂₀ linéaire, ramifié ou cyclique qui peut être substitué par un hétéroatome.

2. La composition de réserve selon la revendication 1, dans laquelle le composant de résine (A) en outre comprend des unités récurrentes ayant la formule générale (3): 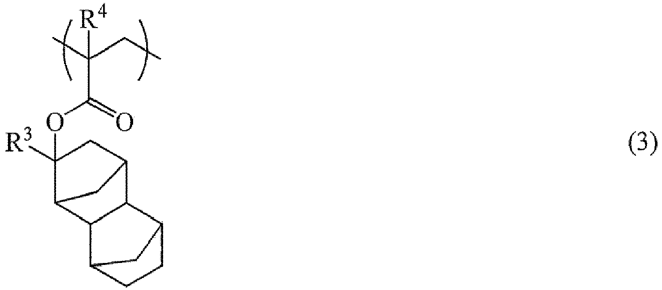 dans laquelle R³ est un alkyle en C₁-C₄ linéaire ou ramifié, et R⁴ est de l'hydrogène ou du méthyle.

3. La composition de réserve selon la revendication 1 ou 2, dans laquelle le composant de résine (A) en outre comprend des unités récurrentes ayant la formule générale (4): 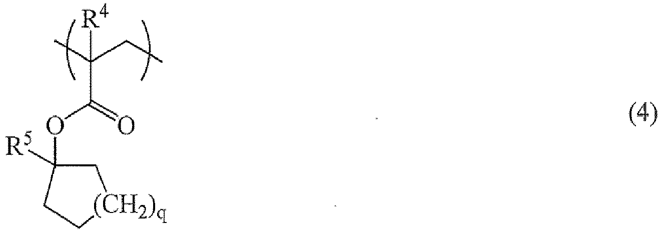 dans laquelle R⁵ est un alkyle en C₁-C₆ linéaire ou ramifié, R⁴ est de l'hydrogène ou du méthyle, et q est 1 ou 2.

4. La composition de réserve selon l'une quelconque des revendications 1 à 3, en outre comprenant (Z) un sel de sulfonium d'acide sulfonique ou d'acide carboxylique ayant la formule générale (Z1) ou (Z2): 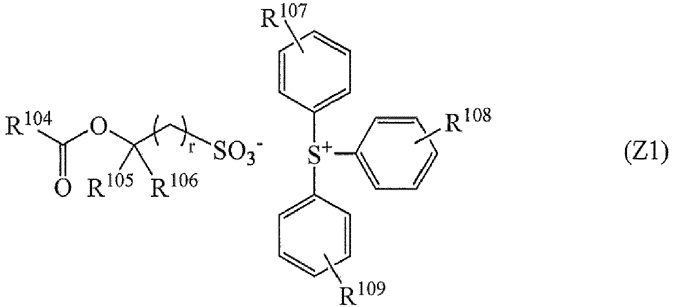 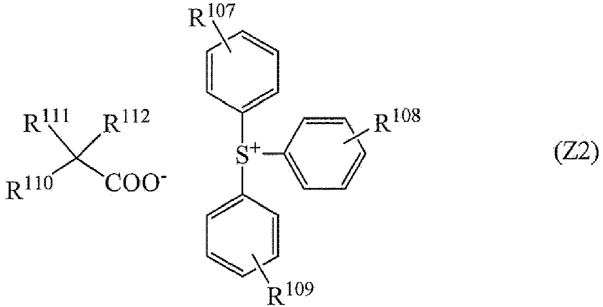 dans lesquelles R¹⁰⁵, R¹⁰⁶, R¹¹¹ et R¹¹² sont de l'hydrogène ou du trifluorométhyle, R¹⁰⁴ est un groupe hydrocarboné monovalent en C₁-C₃₅ linéaire, ramifié ou cyclique qui peut contenir un atome d'oxygène, r est un nombre entier de 0 à 3, R¹¹⁰ est de l'hydrogène, du hydroxyle, un groupe hydrocarboné monovalent en C₁-C₃₅ linéaire, ramifié ou cyclique qui peut contenir un atome d'oxygène, ou un groupe aryle substitué ou non substitué en C₆-C₃₀, R¹⁰⁷, R¹⁰⁸, et R¹⁰⁹ sont chacun indépendamment de l'hydrogène, un groupe alkyle, alcényle ou oxoalkyle substitué ou non substitué en C₁-C₁₀ linéaire ou ramifié, ou un groupe aryle, aralkyle ou aryloxoalkyle substitué ou non substitué en C₆-C₁₈, ou deux ou plusieurs quelconques de R¹⁰⁷,R¹⁰⁸, et R¹⁰⁹ peuvent se lier ensemble afin de former un cycle avec l'atome de soufre.

5. Un procédé pour former un motif, comprenant les étapes de l'application d'une composition de réserve comprenant (A) un composant de résine comprenant des unités récurrentes ayant la formule générale (1) et (B) un générateur de photoacide ayant la formule générale (2) sur un support, la cuisson de la composition afin de former un film de réserve, l'exposition du film de réserve à un rayonnement de haute énergie afin de définir des régions exposées et non exposées, la cuisson, et l'application d'un révélateur solvant organique afin de former un motif négatif, dans lequel la région non exposée du film de réserve est dissoute et la région exposée de film de réserve n'est pas dissoute, 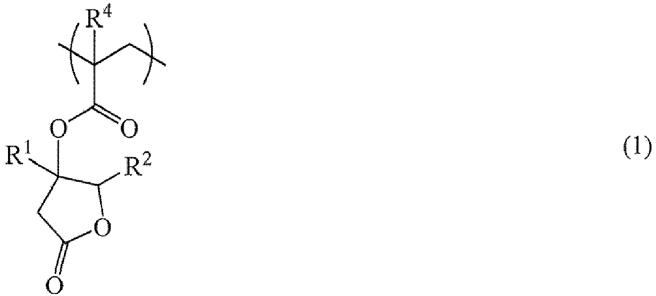 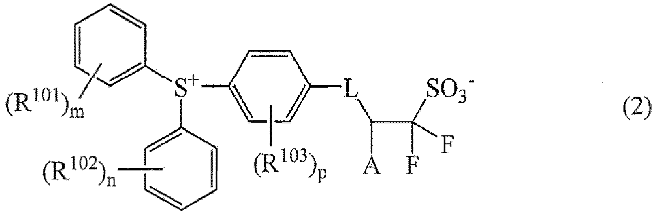 dans lesquelles R¹ et R² sont chacun indépendamment un alkyle en C₁-C₃, R⁴ est de l'hydrogène ou du méthyle, A est de l'hydrogène ou du trifluorométhyle, R¹⁰¹, R¹⁰² et R¹⁰³ sont chacun indépendamment de l'hydrogène ou un groupe hydrocarboné monovalent en C₁-C₂₀ linéaire, ramifié ou cyclique, facultativement substitué par des hétéroatomes, qui peut être lié au cycle de phényle par un hétéroatome, m et n
sont chacun un nombre entier de 0 à 5, p est un nombre entier de 0 à 4, et L est une liaison simple, un atome d'oxygène
ou un groupe hydrocarboné divalent en C₁-C₂₀ linéaire, ramifié ou cyclique qui peut être substitué par un hétéroatome.

6. Le procédé selon la revendication 5, dans lequel le composant de résine (A) en outre comprend des unités récurrentes ayant la formule générale (3): 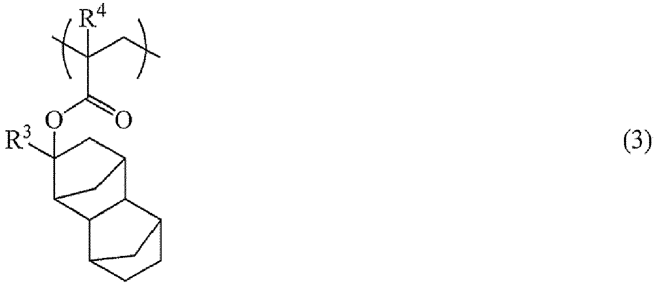 dans laquelle R³ est un alkyle en C₁-C₄ linéaire ou ramifié, et R⁴ est de l'hydrogène ou du méthyle.

7. Le procédé selon la revendication 5 ou 6, dans lequel le composant de résine (A) comprend en outre des unités récurrentes ayant la formule générale (4): 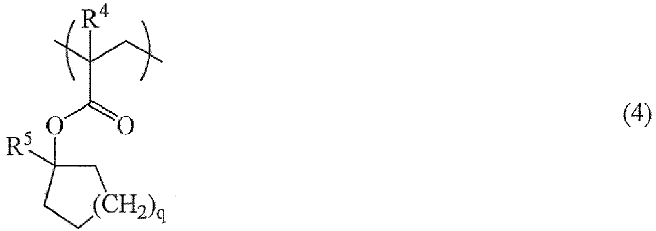 dans laquelle R⁵ est un alkyle linéaire ou ramifié en C₁-C₆, R⁴ est de l'hydrogène ou du méthyle et q est 1 ou 2.

8. Le procédé selon l'une quelconque des revendications 5 à 7, dans lequel la composition de réserve comprend en outre (Z) un sel de sulfonium d'acide sulfonique ou d'acide carboxylique ayant la formule générale (Z1) ou (Z2): 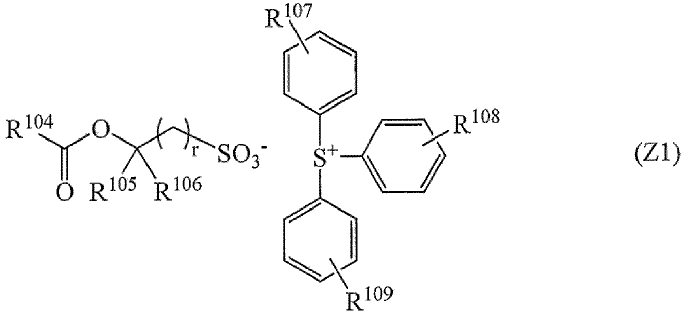 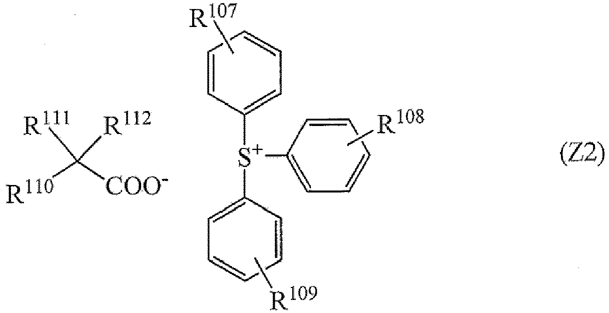 dans laquelle R¹⁰⁵, R¹⁰⁶, R¹¹¹, et R¹¹² sont de l'hydrogène ou du trifluorométhyle, R¹⁰⁴ est un groupe hydrocarboné en C₁-C₃₅ monovalent linéaire, ramifié ou cyclique qui peut contenir un atome d'oxygène, r est un nombre entier de 0 à 3, R¹¹⁰ est de l'hydrogène, du hydroxyle, un groupe hydrocarboné monovalent en C₁-C₃₅ linéaire, ramifié ou cyclique qui peut contenir un atome d'oxygène, ou un groupe aryle en C₆-C₃₀ substitué ou non substitué, R¹⁰⁷, R¹⁰⁸ et R¹⁰⁹ sont chacun indépendamment de l'hydrogène, un groupe alkyle, alcényle ou oxoalkyle en C₁-C₁₀ substitué ou non substitué, linéaire ou ramifié, ou un groupe aryle, aralkyle ou aryloxoalkyl en C₆-C₁₈ substitué ou non substitué, ou deux ou plusieurs quelconques de R¹⁰⁷, R¹⁰⁸ et R¹⁰⁹ peuvent se lier ensemble afin de former un cycle avec l'atome de soufre.

9. Le procédé selon l'une quelconque des revendications 5 à 8, dans lequel le révélateur comprend au moins un solvant organique choisi parmi le groupe constitué par la 2-octanone, la 2-nonanone, la 2-heptanone, la 3-heptanone, la 4-heptanone, la 2-hexanone , la 3-hexanone, la diisobutylcétone, la méthylcyclohexanone, l'acétophénone, la méthylacétophénone, l'acétate de propyle, l'acétate de butyle, l'acétate d'isobutyle, l'acétate d'amyle, l'acétate d'isoamyle, l'acétate de butényle, le formiate de propyle, le formiate de butyle, le formiate d'isobutyle, le formiate d'amyle, le formiate d'isoamyle, le valérate de méthyle, le penténoate de méthyle, le crotonate de méthyle, le crotonate d'éthyle, le propionate de méthyle, le propionate d'éthyle, le 3-éthoxypropionate d'éthyle, le lactate de méthyle, le lactate d'éthyle, le lactate de propyle, le lactate de butyle, le lactate d'isobutyle, le lactate d'amyle, le lactate d'isoamyle, le 2-hydroxyisobutyrate de méthyle, le 2-hydroxyisobutyrate d'éthyle, le benzoate de méthyle, le benzoate d'éthyle, l'acétate de phényle, l'acétate de benzyle, le phénylacétate de méthyle, le formiate de benzyle, le formiate de phényléthyle, le 3-phénylpropionate de méthyle, le propionate de benzyle, le phénylacétate d'éthyle et l'acétate de 2-phényléthyle.

10. Le procédé selon l'une quelconque des revendications 5 à 9, dans lequel l'étape consistant à exposer le film de réserve à un rayonnement à haute énergie comprend la lithographie par laser excimère KrF d'une longueur d'onde de 248 nm, la lithographie par laser excimer ArF d'une longueur d'onde de 193 nm, la lithographie EUV d'une longueur d'onde de 13,5 nm, ou la lithographie EB.
